# EUROPÄISCHE PATENTSCHRIFT

(11) **EP 1 699 898 B1**
(45) Veröffentlichungstag und Bekanntmachung des Hinweises auf die Patenterteilung: **29.10.2008**
(21) Anmeldenummer: 04816282.0
(22) Anmeldetag: 29.12.2004
(51) Int. Cl.: C09K 11/06, H01L 51/30

(54) **POLYMERE, PHOSPHORESZIERENDE, ORGANISCH HALBLEITENDE EMITTERMATERIALIEN AUF BASIS PERARYLIERTER BORANE, VERFAHREN ZU DEREN HERSTELLUNG UND VERWENDUNGEN DAVON**
POLYMERIC, PHOSPHORESCENT, ORGANICALLY SEMI-CONDUCTIVE EMITTER MATERIALS BASED ON PERARYLATED BORANES, METHOD FOR THEIR PRODUCTION AND USE THEREOF
MATIERES EMETTRICES POLYMERES, PHOSPHORESCENTES ET ORGANIQUEMENT SEMI-CONDUCTRICES, A BASE DE BORANE PERARYLE, PROCEDE DE REALISATION ET UTILISATIONS ASSOCIES

(30) Priorität: 29.12.2003 DE 10361385
(43) Veröffentlichungstag der Anmeldung: 13.09.2006
(73) Patentinhaber: OSRAM Opto Semiconductors GmbH, 93055 Regensburg (DE)
(72) Erfinder: KANITZ, Andreas, 91315 Höchstadt (DE); ROGLER, Wolfgang, 91096 Möhrendorf (DE); ROTH, Wolfgang, 91080 Uttenreuth (DE); SONNABEND, Thomas, 06406 Bernburg (DE); WÖRLE, Jasmin, 90763 Fürth (DE)
(74) Vertreter: Epping - Hermann - Fischer
(86) Internationale Anmeldenummer: PCT/DE2004/002833
(87) Internationale Veröffentlichungsnummer: WO 2005/063919

(56) Entgegenhaltungen:
- WO-A-03/091355
- US-A- 5 681 870
- US-A- 6 057 078
- US-A1- 2003 091 862

## Beschreibung

Die Erfindung betrifft luminophore Verbindungen mit halbleitenden Eigenschaften sowie deren Herstellung und ihre Anwendung in organischen Leuchtdioden (OLEDS).

Bekannt sind sogenannte "small molecules" (also Einzelmoleküle mit luminophoren Eigenschaften für OLED-Anwendungen) mit perarylierten Boranstrukturen beispielsweise aus der Veröffentlichung von M. Kinoshita et al./"Boron containing materials for Blue/blue-violet Electroluminescence".
Ebenso sind auch Luminophore bekannt, die als "small molecule"-OLED-Anwendungen insbesondere phosphoreszieren, beispielsweise Veröffentlichungen und Patente von M. E. Thompson und S. R. Forrest.

Nachteilig an den small molecules ist, dass sie schlecht applizierbar sind, weil sich Einzelmoleküle als OLED-Schichten nicht durch spin coating oder andere Beschichtungsmethoden herstellen lassen, sondern kostspielige Aufbringungsmethoden erfordern.

In der US 6,057,078 wird Polymesitylboran, sowie seine Verwendung als Elektronenakzeptor und Thermalinitiator beschrieben. US 2003/0091862 A1 offenbart phosphoreszierende Verbindungen und ihre Verwendung in organischen Leuchtdioden. US 5,681,870 A beschreibt Keramiken mit organischen Borpolymeren und die PCT-Patentanmeldung WO 03/091355 A2 offenbart in Lösung prozessierbare, phosphoreszierende polymere Materialien für organische Leuchtdioden.

Aufgabe der Erfindung ist es, neue organische, polymere halbleitende Emitter- und Transportmaterialien zu schaffen, die in organischen Leuchtdioden bzw. Leuchtdiodendisplays verwendet werden können, die präperativ gut zugänglich und in Massenfertigungsprozessen leicht verarbeitbar sind.

Gegenstand der Erfindung sind phosphoreszierende Copolyarylborane des Typs K, 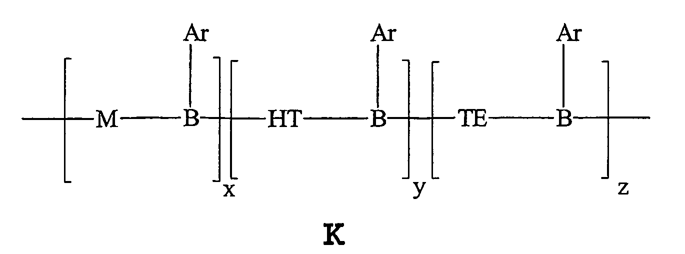 wobei Folgendes gilt:
**x,y** und **z** sind molare Teile von Komponenten und ergeben in Summe gleich 1, wobei der Anteil z einen Wert von 0,01 bis 0,1 hat und die Verhältnisse der Teile x und y im Bereich der Differenz zu 1 frei wählbar sind,
an den Enden sind Wasserstoff-Atome gebunden,
   **M, HT** und **TE** stehen für die Art der jeweiligen Arylenkomponente im Copolymer,
dabei dient **M** als Matrixstruktur und hat eine Arylenstruktur, bevorzugt die 2,7-Fluorenylenstruktur, die in 9-Position leicht durch unverzweigte und/oder verzweigte Alkylreste (C1 bis C10) substituiert werden kann, wobei unter dem Begriff Arylenstruktur eine beliebige bivalent verbindende ein- oder mehrkernige aromatische und/oder heteroaromatische Struktur verstanden wird, wie beispielsweise in Tabelle 1 (a - x) angegeben ist, 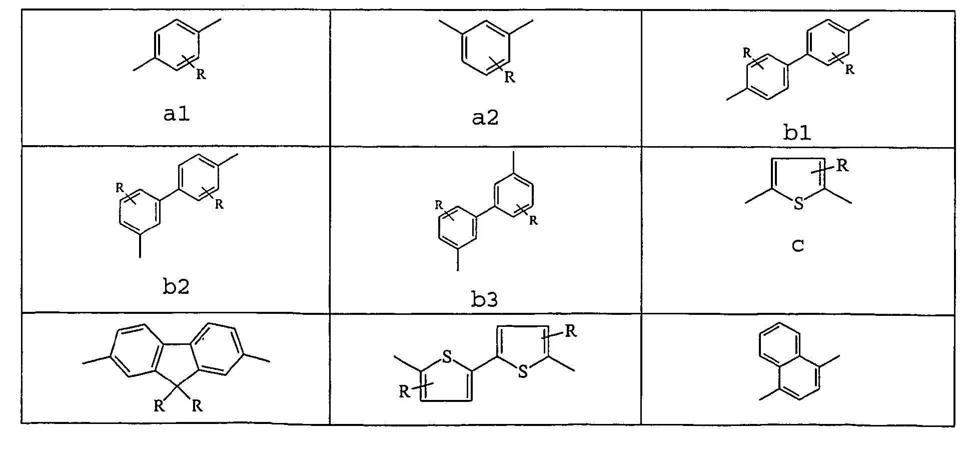 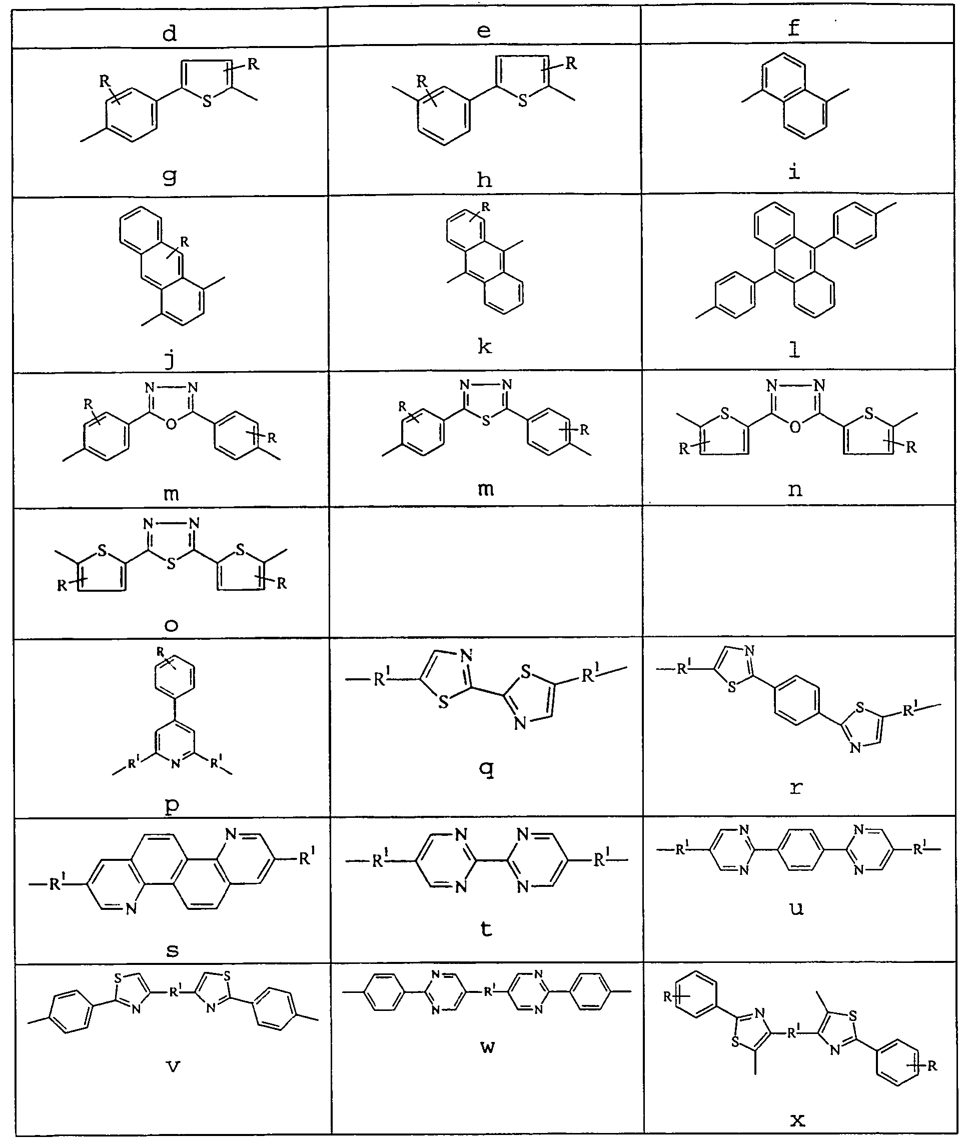
deren Löslichkeit in organischen Lösungsmitteln durch zusätzliche beliebige Anordnung von einem oder mehreren unverzweigten und/oder verzweigten Alkylsubstituenten bzw. und/oder Alkoxysubstituenten **R** verbessert werden kann; oder aber auch durch alkyl-substituierte Arylen-Substituenten **R¹,** wobei bevorzugt einfach synthetisierbare mit verzweigten oder unverzweigten Alkylgruppierungen von C5 bis C10 ausgerüstete 2,7-disubstituierte 9,9-Dialkylfluorenylen-strukuren angewandt werden.

**HT** ist eine lochtransportfähige substituierte 2-Aminothiophen bzw. -thiazolstruktur mit den Variationsmöglichkeiten dass
**HT(a),** eine substituierte (2,2'diamino-5,5'bisthienyl)-4,4'-ylen-struktur,
**HT(b)** eine substituierte Bis-N,N'-(thien-2-yl)- bzw. Bis-N,N'-(1,3-thiazol-2-yl)-diaminoarylen-strukur und
**HT(c)** eine substituierte (2,2'-Diamino)-bis-(4,4'thienyl)-arylen-5,5'-ylen-struktur ist, jeweils gemäß unten gezeigten Formeln sein kann,
wobei die Substituenten **R²**, **R³** und **R⁴** Arylgruppierungen **Ar** darstellen, die wiederum durch zu sätzliche beliebige Anordnung von einem oder mehreren unverzweigten und/oder verzweigten Alkylsubstituenten bzw. und/oder Alkoxysubstituenten **R** substituiert sein können, dabei sind aber die Bedeutungen der Substituenten **Rⁿ** mit gleichem Index **n** identisch und die der Substituenten **R¹** gleichbedeutend mit der Substituentenauswahl für die Arylenkomponente **Md;**
dabei gilt für **HT(b)** zusätzlich, dass **X** gleich **N** oder **C-R** ist. Die HT-Komponente dient zur optimalen Einstellung der Lochtransporteigenschaften und zur längerwelligen Emissionskorrektur des Copolymers 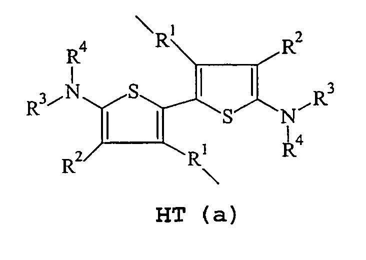 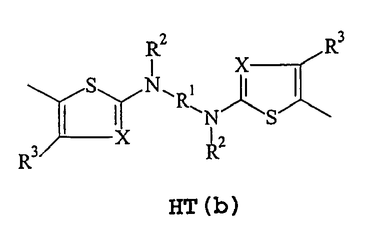 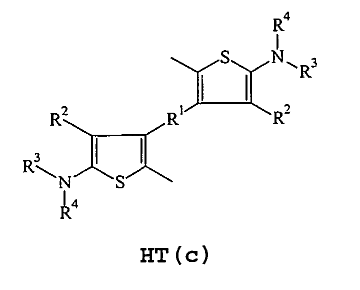 **TE** ist ein bivalenter phosphoreszierender Organometallkomplex, folgender Struktur: 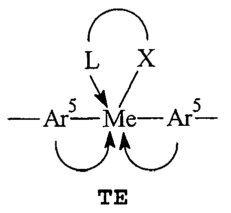 **Me** hat die Bedeutung eines Metalls der 8. Nebengruppe (Iridium, Ruthenium, Osmium oder Platin ),bevorzugt Iridium. **Ar⁵** ist ein mit dem Metall komplexierbarer Arylenligand, der gleichzeitig auch eine Funktion zur polymeren Anbindung trägt,
der Ligand **(L-X)** gilt nicht für Platinkomplexe,
bei allen anderen Metallkomplexen sind ebenfalls kompexierbare Arylenliganden **(a),** 1,3-Diketonatliganden **(b),** Bis-thiazolylmethan- bzw. Bis-thiazolylamin-Liganden **(c),** Picolinat- **(d),** N-Alkylsalicylaldimino- **(e)** oder 8-Hyroxychinolat-Liganden **(f)** eingeführt,
bevorzugt die folgenden Strukturen:
a) Einkernkomplexe:

| | |
|---|---|
| 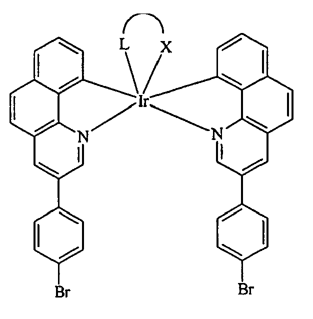 | 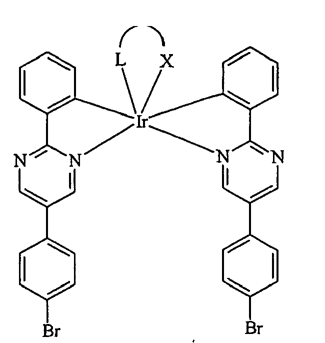 |
| **TE (a)** | **TE (b)** |
| 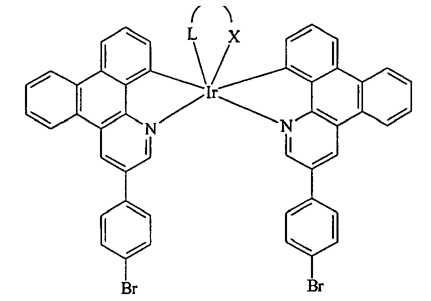 | |
| **TE(c)** | |
| 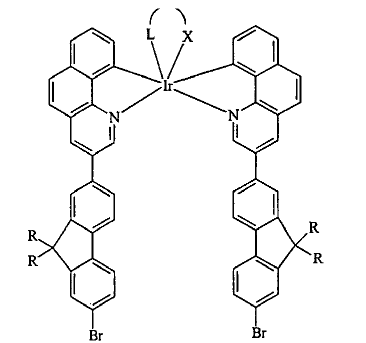 | 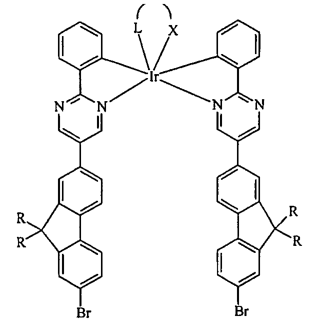 |
| **TE (d)** | **TE (e)** |

b) Zweikernkomplexe:

| |
|---|
| 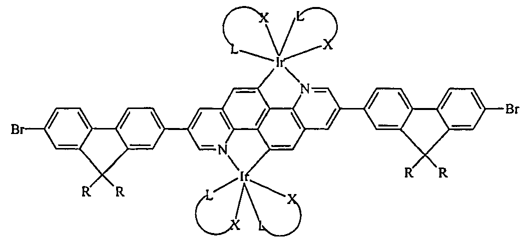 |
| **TE(f)** |
| 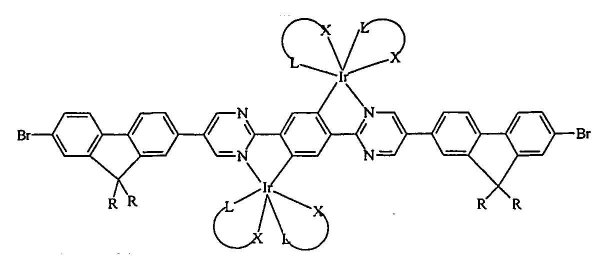 |
| **TE(g)** |

zugehörige **LX-Liganden:**

| | | | |
|---|---|---|---|
| 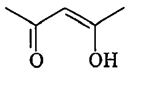 | | 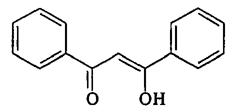 | 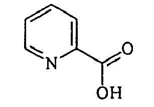 |
| **b1** | | **b2** | d |
| 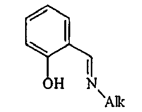 | | 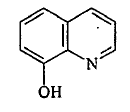 | 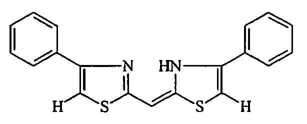 |
| **E** | | **f** | **c1** |
| 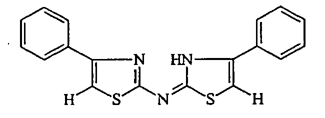 | | 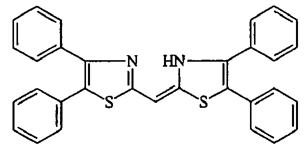 | 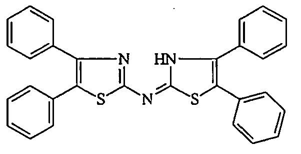 |
| **c2** | | **c3** | **c4** |
| 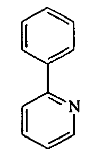 | | 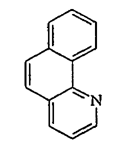 | 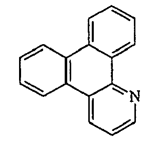 |
| **a1** | | **a2** | **a3** |
| 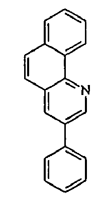 | 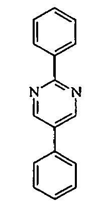 | 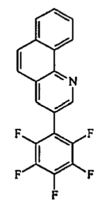 | 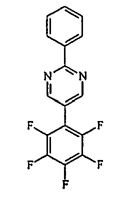 |
| **a4** | **a5** | **a6** | **a7** |

**Ar** ist ein carbocyclischer oder heterocyclischer Arylrest, dessen Wasserstoffatome auch beliebig durch einen oder mehrere verzweigte oder unverzweigte Alkylreste oder Alkoxyreste (C1 bis C10) sowie Phenylresten und/oder Diphenyl- bzw. Naphthylphenyl-amino-gruppierungen ersetzt sein können; bevorzugt Mesityl, Phenyl, Biphenylyl, 1-Naphthyl, 2-Naphthyl, 2-Diphenyl- bzw. 2-Naphthylphenylamino-3,4-diphenyl-thien-5-yl- und 2-Diphenyl- bzw. 2-Naphthylphenylamino-3,4-diphenyl-1,3-thiazol-5-yl.

Weiterhin ist Gegenstand der Erfindung ein Verfahren zur Herstellung der phosphoreszierenden Co-polyarylborane des Typs **K** nach dem allgemeinen Herstellungsschema. 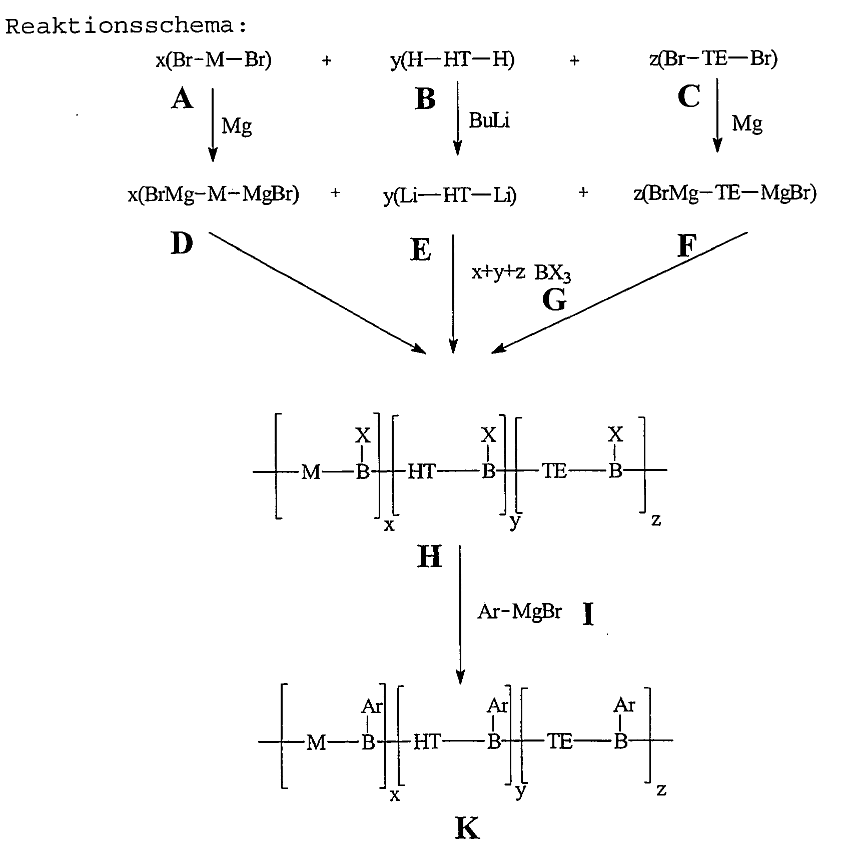 wobei von den bromsubstituierten Arylenkomponenten **M**, den Lochtransportkomponenten **HT** und den bromsubstituierten, phosphoreszierenden Organometallkomplexen **TE** ausgegangen wird, diese werden entweder in einer Grignardreaktion (siehe Schema) oder durch Lithiierung umgepolt und darauffolgend durch Bor substituiert, bei den Produkten **H** dieser Reaktion werden wiederum die Halogene am Bor mittels eines Grignard-reagenzes (siehe Schema) oder eines entsprechenden lithiierten Reagenzes durch organische Reste R ersetzt.

Schließlich ist Gegenstand der Erfindung die Verwendung der Co-polyarylborane des Typs **K** in organischen Leuchtdioden als triplett-emittierende und Elektronen transportierende Schicht.

Offenbart ist darüber hinaus auch die Verwendung der Copolyarylborane **K** als Blends von Einzelkomponentenpolymeren, also für den Fall, dass zwei der Verhältnisvariablen x,y und/oder z den Wert Null haben.

X,y,und z sind die Verhältniszahlen, die angeben, in welchen Verhältnissen zueinander die polymeren Einzelkomponenten copolymerisiert werden. Die polymeren Einzelkomponenten können auch jeweils als Material für eine elektrolumineszierende Schicht genutzt werden.

### Allgemeine Beschreibung des Syntheseweges:

Ausgehend von den Ausgangssynthons, **A,B** und **C,** werden Grignardreaktionen mit Magnesium Tetrahydrofuran oder Lithiierungen mit BuLi in Ether durchgeführt. Die Grignardprodukte bzw. die Lithiumorganyle **D, E** und **F** werden dann einzeln oder in beliebigen gewünschten Verhältnissen in der Siedehitze des THF mit einem Borhalogenid **G** (beispielsweise Bortrifuoridetherat) so umgesetzt, daß die molare Summe der Grignardkomponenten und/bzw. Lithiumorganyle der molaren Menge des Borhalogenids entspricht. Dabei führt die Reaktion der bifunktionellen Grignardkomponenten bei ca. 70°C nur zu einem linearen Co-Polyfluorarylenboran **H.**

Danach synthetisiert man eine weitere monofunktionelle Grignardkomponente **I,** die man nach Austausch des Lösungsmittel THF duch Toluol (nun in der Siedehitze des Toluols) im molaren Verhältnis zutropft. Nach 5-stündigem Sieden bei ca. 120°C führt dies zur Substitution des restlichen Fluors durch den Arylrest der Grignardkomponente **I** unter Bildung eines phosphoreszierenden Co-Polyarylboranderivats **K,** welches aufgrund der Komponentenverhältnisse maßgeschneiderte elektrische und optische Eigenschaften besitzt.

Die phosphoreszierenden Polyarylboranderivate **K** erhält man auch, wenn man anstelle der Grignardverbinung **I** die entsprechende lithiierte Komponente unter Trockeneiskühlung in Ether und/oder Tetrahydrofuran synthetisiert und mit dem zuvor synthetisierten Co-Polyfluorarylenboran **H** umsetzt.

### Ausführungsbeispiele:

### Synthese konjugierter, kondensierter und oligo Arylsysteme

Für den Fall, dass die benötigten Arylsysteme nicht kommerziell verfügbar sind, werden sie durch bekannte C-C-Verknüpfungs-reaktionen (beispielsweise Suzuki-Kupplung) dargestellt, zuvor werden an mindestens einem Kupplungsbaustein Alkylierungen bzw. Alkoxylierungen durchgeführt, um eine gute Löslichkeit der daraus zu bildenden polymeren Materialien anzustreben.

### Synthese der Dibrom-arylene M

Darstellung von 9,9-diheptyl-2,7-dibromfluorenen

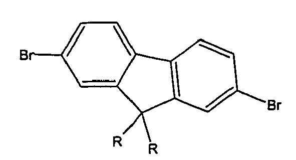

### a)Darstellung von 9,9-Diheptyl-fluoren

0.2 mol Fluoren werden in 300 ml DMSO bei 80°C gelöst. Zur Lösung werden 0.01 mol Phasentransferkatalysator (Aliquot) gegeben und weitere 5 Minuten gerührt. Für die Alkylierung werden 0.5 mol 50%ige Natronlauge und 0.5 mol Heptylbromid benötigt. Die Zugabe erfolgt in drei Stufen, wobei mit der Zugabe von ein Drittel der eingesetzten Menge Natronlage begonnen wird. Die Lösung verfärbt sich ins Tiefrote und wird nach Zugabe von Heptylbromid langsam gelb. Wenn die Lösung gelb geworden ist, wird das zweite Drittel Natronlauge zugegeben usw. Das Ende der Reaktion wird mittels DC an RP18 in Acetonitril kontrolliert.
Das Reaktionsgemisch wird dreimal mit Ether und Wasser extrahiert und die organische Phase abgetrennt.
Nach abdestillieren aller Lösungsmittel (Ether, DMSO, Heptanol) liegt das Produkt als gelbes Öl vor (HPLC-Kontrolle), es wird als Rohprodukt weiterverarbeitet. Zur Darstellung von 9, 9- Dialkylfluorenen mit anderen Alkylgruppen als der Heptylgruppe werden dementsprechend Alkylbromide R-Br (R z. B. Decyl- oder 2-Ethylhexyl-Gruppe) eingesetzt.

### b)Darstellung von 2,7-Dibrom-9,9-diheptylfluoren

0.2 mol Diheptylfluoren werden in 300 ml Chloroform gelöst und zum Sieden erhitzt. In der Dunkelheit werden langsam 0.4 mol Brom, gelöst in Chloroform zugetropft. Die Reaktion wird ca. 12 Stunden in der Siedehitze gerührt. Wenn sich die Reaktionslösung entfärbt hat, ist die Bromierung beendet (DC-Kontrolle an RP 18 in Acetonitril). Nach Erkalten der Lösung wird das gesamte Chloroform abdestilliert und das Produkt in Methanol als weiße Kristalle gefällt. Nach Chromatographie des Produktes an Silicagel in Cyclohexan erhält man HPLCreines Produkt, mp: 45-6°C.

### Synthese der Dibrom-arylene HT / Aufbau der Strukturen HT(a)

### 1. Dialkylierung von 2-Bromfluoren

0,1 mol 2-Bromfluoren werden in DMSO unter Stickstoffatmosphäre bei ca. 50°C unter ständigem Rühren gelöst. Das gelöste 2-Bromfluoren wird mit 0,25 mol Kalium-tert.-butylat versetzt, woraufhin sich das Reaktionsgemisch dunkelrot färbt. Nach 5 Minuten werden 0,25 mol ein Alkylbromid R-Br zugegeben; die Reaktion läuft bei Raumtemperatur über Nacht und ist zu Ende, wenn ein Farbumschlag von rot nach hellgelb eintritt.
Die DMSO-Phase wird mit Wasser gewaschen und mit Ether extrahiert. Der Ether wird mittels Rotationsverdampfer abdestilliert und das Produkt in Form hellgelber Kristalle mit Methanol gefällt.
1a) 2-Brom-9,9-diheptylfluoren 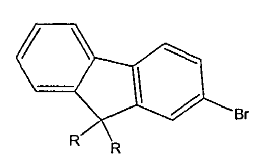
   Auf diese Art wird beispielsweise 2-Brom-9,9-diheptylfluoren (mp: 32°C) aus 2-Bromfluoren und Heptylbromid in Gegenwart von Kalium-tert.-butylat hergestellt.

### 2. Chloracetylierung von 9,9-Dialkyl-2-bromfluorenen

0,1 mol 9,9-Diheptyl-2-bromfluoren werden in Methylenchlorid vorgelegt und mit flüssigem Stickstoff auf -15°C gekühlt. Bei -15°C werden 0,15 mol Chloracetylchlorid und daraufhin 0,3 mol Aluminiumchlorid langsam zugegeben. Die Reaktion wird nun über Nacht (mindestens 12h) gerührt.

Das Gemisch wird in Eis/Wasser/HCl (500ml:500ml:50ml) geschüttet und 20 Minuten gerührt. Danach wird nochmals mit Wasser gewaschen. Die organsiche Phase wird abgetrennt und das Lösungsmittel abdestilliert. Das Produkt fällt in Form weißer Kristalle in Methanol aus.
2a) 2-Brom-7-chloracetyl-9,9-diheptylfluoren 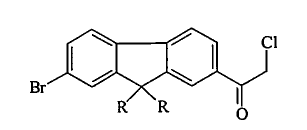
   Auf diese Art wird beispielsweise 2-Brom-7-chloracetyl-9,9-diheptylfluoren (mp: 83-4°C) aus 2-Brom-9,9-diheptylfluoren und Chloracetylchlorid unter Friedel-Crafts-Bedingungen hergestellt.

### 3. Synthese arylierter Carbonsäureamide

In einem 2 l-Dreihalskolben mit Rückflusskühler, Magnetrührer, Tropftrichter und Inertgasdurchfluss wird jeweils 1 mol eines sekundären Diarylamins in 600 ml Dioxan gelöst. Das jeweils benötigte Carbonsäurehalogenid wird danach in äquivalenter Menge zugetropft. Anschließend wird das Reaktionsgemisch unter Rückfluss erhitzt, bis die gesamte Menge des bei der Reaktion entstehenden Hydrohalogenids vom Inertgasstrom entfernt worden ist. Durch dünnschichtchromatographische Kontrolle kann das Ende der Reaktion zusätzlich detektiert werden. Die Reaktionslösung wird dann abgekühlt und in mindestens die 2-fache Menge Wasser eingerührt. Dabei scheidet sich in den meisten Fällen ein Öl ab, welches nach einigen Stunden erstarrt ist. Die wässrige Phase wird abgetrennt und das Rohprodukt aus Ethanol umkristallisiert. Die Ausbeute beträgt jeweils mindestens 90%. 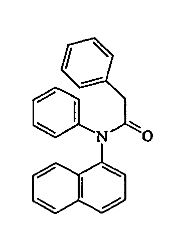
3a) Auf diese Art wird beispielsweise 2-Phenylessigsäurephenyl-1-naphthylamid (Fp.:85 -88°C) aus Phenyl-1-naphthylamin und 2-Phenylacetylchlorid hergestellt. 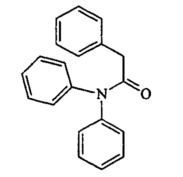
3b) Auf diese Art wird beispielsweise 2-Phenylessigsäurediphenylamid (Fp.: 71-72°C) aus Diphenylamin und 2-Phenylacetylchlorid hergestellt.

### 4. Synthese arylierter Thiocarbonsäureamide

0,5 mol des jeweiligen arylierten Carbonsäureamids und die äquivalente Menge Lawesson-Reagenz (hergestellt aus Anisol und Phosphorpentasulfid) werden in einer Rückflussapparatur mit Inertgasdurchfluss in 750 ml Diglykoldiethylether suspendiert, und dann wird 6 h bei 100°C gerührt. Dabei bildet sich eine klare Lösung, aus der in der Kälte in einigen Fällen das Reaktionsprodukt auskristallisiert. Um das Produkt vollständig zu isolieren, wird die Reaktionsmischung in die doppelte Menge Wasser eingerührt, die sich oft bildende ölige Phase lässt man dann kristallisieren. Danach wird das Produkt von der wässrigen Phase abgetrennt und aus Methanol umkristallisiert. Die Ausbeute beträgt jeweils mindestens 90%. 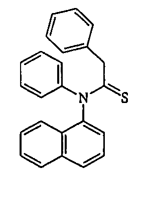
4a) Auf diese Art wird beispielsweise 2-Phenylthioessigsäurephenyl-1-naphthylamid (Fp.: 100 - 103°C) aus 2-Phenylessigsäurephenyl-1-naphthylamid und dem Lawesson-Reagenz hergestellt. 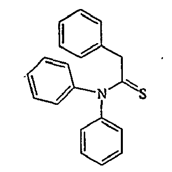
4b) Auf diese Art wird beispielsweise 2-Phenylthioessigsäurediphenylamid (Fp.: 142-144°C) aus 2-Phenylessigsäurediphenylamid und dem Lawesson-Reagenz hergestellt.

### 5. Darstellung arylierter 2-Aminothiophenderivate

0,1 mol Haloacylarylderivat werden mit 0,1 mol 2-Phenylthioessigsäurediarylamid (Beispiel 4b) in Tetrahydrofuran vorgelegt und 30 Minuten unter Stickstoffatmosphäre refluxiert. Nach 30 Minuten werden 0,1mol Trimethylamin zugegeben und nochmals 30 Minuten refluxiert. Das Produkt wird in Form gelblicher Kristalle in Methanol gefällt.
5a) 2-(Phenyl-1-naphthylamino)-3-phenyl-4-p-bromphenylthiophen 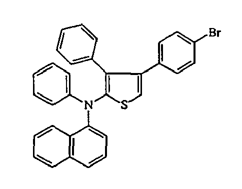
   Auf diese Art wird beispielsweise 2-(Phenyl-1-naphthylamino)-3-phenyl-4-p-bromphenylthiophen (ESI-MS: M+1⁺ = 532) aus 2-Phenylthioessigsäurephenyl-1-naphthylamid und p-Bromphenacylbromid hergestellt.
5b) 2-(Phenyl-1-naphthylamino)-3-phenyl-4-(7-brom-9,9-diheptyl-fluoren-2-yl)-thiophen

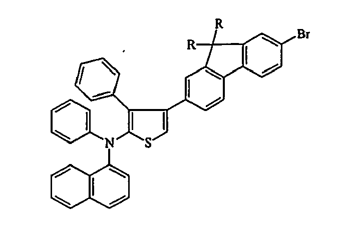

Auf diese Art wird beispielsweise 2-(Phenyl-1-naphthylamino)-3-phenyl-4-(7-brom-9,9-diheptyl-fluoren-2-yl)-thiophen mit R= Heptyl (ESI-MS: M+1⁺ = 816) aus 2-Phenylthioessigsäurephenyl-1-naphthylamid und 2-Chloracetyl-7-brom-9,9-diheptyl-fluoren hergestellt.

### 6.) Darstellung von Dibromarylenderivaten mit Lochtransporteigenschaften durch Oxydation der 2-Aminothiophenderivate

0,1 mol 2-Aminothiophenderivat werden mit 0,5 mol FeCl₃ in Methylenchlorid vorgelegt und einen Tag gerührt. Das Produkt wird mit Wasser und 0,1 mol Triethylamin versetzt und das organische Lösungsmittel abdestilliert. Das Produkt fällt nun in Form von gelben Kristallen in der zurückbleibenden Wasserphase aus. Reinigung durch Säulenchromatographie an Silicagel mit Toluol)
6a) Bis-[2-(Phenyl-1-naphthylamino)-3-phenyl-4-(7-brom-9,9-diheptyl-fluoren-2-yl]-5,5'-thienyl 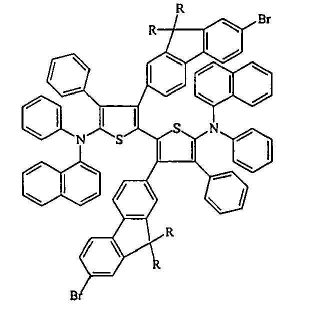
   Auf diese Art wird beispielsweise Bis-[2-(Phenyl-1-naphthylamino)-3-phenyl-4-(7-brom-9,9-dialkyl-fluoren-2-yl]-5,5'-thienyl mit R= Heptyl (ESI-MS: M+1⁺ = 1629) aus 2-(Phenyl-1-naphthylamino)-3-phenyl-4-(7-brom-9,9-diheptylfluoren-2-yl-thiophen und Eisen-III-chlorid hergestellt.
6b) Bis-[2-(Phenyl-1-naphthylamino)-3-phenyl-4-(4-bromphenyl)]-5,5'-thienyl

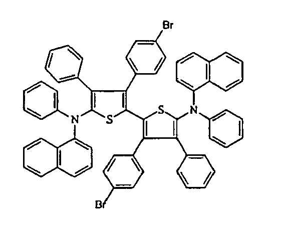

Auf diese Art wird beispielsweise Bis-[2-(Phenyl-1-naphthylamino)-3-phenyl-4-(4-bromphenyl)]-5,5'-thienyl (mp: 133-4°C), (ESI-MS: M+1⁺ = 1061) aus 2-(Phenyl-1-naphthylamino)-3-phenyl-4-(4-bromphenyl)-thiophen und Eisen-III-chlorid hergestellt.

### Synthese der Dibrom-arylene HT / Aufbau der Strukturen HT(b)

### 1. Synthese arylierter Biscarbonsäureamide

In einem 2 1-Dreihalskolben mit Rückflusskühler, Magnetrührer, Tropftrichter und Inertgasdurchfluss wird jeweils 1 mol eines sekundären arylierten Bisamins in 600 ml Dioxan gelöst. Das jeweils benötigte Carbonsäurehalogenid wird danach in äquivalenter Menge zugetropft. Anschließend wird das Reaktionsgemisch unter Rückfluss erhitzt, bis die gesamte Menge des bei der Reaktion entstehenden Hydrohalogenids vom Inertgasstrom entfernt worden ist. Durch dünnschichtchromatographische Kontrolle kann das Ende der Reaktion zusätzlich detektiert werden. Die Reaktionslösung wird dann abgekühlt und in mindestens die 2-fache Menge Wasser eingerührt. Dabei scheidet sich in den meisten Fällen ein Öl ab, welches nach einigen Stunden erstarrt ist. Die wässrige Phase wird abgetrennt und das Rohprodukt aus Ethanol umkristallisiert. Die Ausbeute beträgt jeweils mindestens 90%. 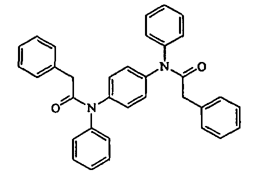
1a) Auf diese Art wird beispielsweise N,N'-Di(2-phenylacetyl)-N,N'-diphenyl-phenylen-1,4-diamin (Fp.: 190°C) aus N,N'Diphenyl-p-phenylendiamin und 2-Phenylacetylchlorid hergestellt.

### 2. Synthese arylierter Bisthiocarbonsäureamide

0,5 mol des jeweiligen arylierten Biscarbonsäureamids und die äquivalente Menge Lawesson-Reagenz (hergestellt aus Anisol und Phosphorpentasulfid) werden in einer Rückflussapparatur mit Inertgasdurchfluss in 750 ml Diglykoldiethylether suspendiert, und dann wird 6 h bei 100°C gerührt. Dabei bildet sich eine klare Lösung, aus der in der Kälte in einigen Fällen das Reaktionsprodukt auskristallisiert. Um das Produkt vollständig zu isolieren, wird die Reaktionsmischung in die doppelte Menge Wasser eingerührt, die sich oft bildende ölige Phase lässt man dann kristallisieren. Danach wird das Produkt von der wässrigen Phase abgetrennt und aus Methanol umkristallisiert. Die Ausbeute beträgt jeweils mindestens 90%. 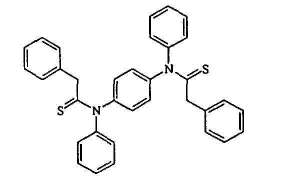
2a) Auf diese Art wird beispielsweise N,N'-Di(2-phenylthioacetyl)-N,N'-diphenyl-phenylen-1,4-diamin (Fp.:224 - 227°C) aus N,N'-Di(2-phenylacetyl)-N,N'-diphenyl-phenylen-1,4-diamin und dem Lawesson-Reagenz hergestellt.

### 3. Darstellung arylierter Bis-2-aminothiophenderivate

0,2 mol Haloacylarylderivat werden mit 0,1 mol N,N'-Di(2-phenylthio-acetyl)-N,N'-diphenyl-phenylen-1,4-diamin in Tetrahydrofuran vorgelegt und 30 Minuten unter Stickstoffatmosphäre refluxiert. Nach 30 Minuten werden 0,2mol Trimethylamin zugegeben und nochmals 30 Minuten refluxiert. Das Produkt wird in Form hellgelber Kristalle in Methanol gefällt. 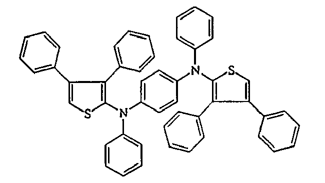
3a) Auf diese Art wird beispielsweise N,N'-Diphenyl-N,N'-dithien-3,4-diphenyl-2-yl-phenylen-1,4-diamin (Fp.:266-268°C) aus N,N'-Di(2-phenylthio-acetyl)-N,N'-diphenyl-phenylen-1,4-diamin und Phenacylbromid hergestellt.

### Synthese der Dibrom-arylene HT / Aufbau der Strukturen HT(c)

### 1. Darstellung von 2,2'-Diamino-4,4'-bisthienylarylenen

0,1 mol Bis-(haloacyl)-arylenderivat werden mit 0,2 mol 2-Aryl-thioessigsäurediarylamid in Tetrahydrofuran vorgelegt und 30 Minuten unter Stickstoffatmosphäre refluxiert. Nach 30 Minuten werden 0,2mol Trimethylamin zugegeben und nochmals 30 Minuten refluxiert. Das Produkt wird in Form farbloser Kristalle in Methanol gefällt. 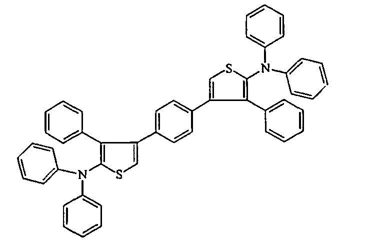
1a) Auf diese Art wird beispielsweise 2,2'-Diphenylamino-3,3'-diphenyl-4,4'-bisthienyl-p-phenylen (Fp.:232-235°C) aus 2-Phenyl-thioessigsäurediphenylamid und Bis-ω-Bromacetyl-p-phenylen hergestellt.

### Synthese der Dibrom-arylen-triplettemitter-komplexe TE

### a)Synthese der Liganden:

a1) Darstellung von 2-(4-Bromphenyl)-N,N,N',N'-tetramethylvinamidinium-perchlorat:
   0,1 mol 4-Bromphenylessigsäure wird mit frisch bereiteten Vilsmeyer-Komplex (DMF/POCl3) 3h bei 80°C erwärmt. Nach dem Abdestillieren des DMF im Vakuum wird die Reaktionsmischung in eine 0,1 mol Natriumperchlorat enthaltende kalte wässrige Lösung gegeben. Das ausgefallene Salz wird abgesaugt und mit etwas Ethanol und Ether gewaschen und trocken gesaugt.
   weiße Kristalle Fp: 145-7°C 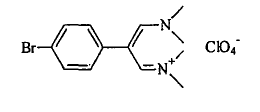
a2) Darstellung von 3-(4-Bromphenyl)-h-benzochinolin 0,05 mol Vinamidiniumsalz a1 werden mit 0,55 mol 1-Naphthylamin in DMF am Rückfluß erhitzt, nach 4-5h läßt man abkühlen und saugt den ausgefallenen Kristallbrei ab, wäscht abschließend mit Ethanol und Ether.
   weiße fluoreszierende Kristalle Fp: 160°C 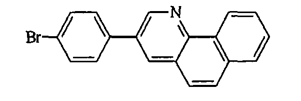
a3) Darstellung von 5-(4-Bromphenyl)-2-phenylpyrimidin 0,05 mol Vinamidiniumsalz a1 werden mit 0,055 mol Benzamidinhydrochlorid in Pyridin am Rückfluß erhitzt, nach 12h läßt man abkühlen destilliert das Pyridin ab und versetzt die Reaktionsmischung mit Methanol. Die ausgefallenen Kristalle saugt man ab, wäscht abschließend mit Ethanol und Ether.
   weiße fluoreszierende Kristalle Fp: 194°C 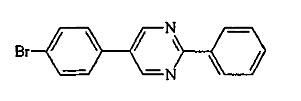
a4) Darstellung von 3-(4-Bromphenyl)-f,h-dibenzochinolin 0,05 mol Vinamidiniumsalz 1 werden mit 0,055 mol 9-Aminophenanthren in DMF am Rückfluß erhitzt, nach 4-5h läßt man abkühlen und saugt den ausgefallenen Kristallbrei ab, wäscht abschließend mit Ethanol und Ether.
   fluoreszierende Kristalle Fp: °C

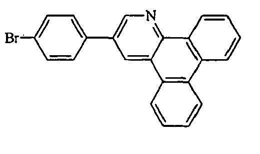

### b)Synthese der Komplexe:

### 1) Allgemeine Vorschrift zur Synthese von Ir-di-µ-chlorokomplexen:

0,01 mol Iridiumchlorid werden mit 2,1 Äquivalenten eines 2-Phenyl-pyridin-strukturelements (z.B. die Liganden a2, a3) in 100ml Methoxyethanol und 25ml Wasser am Rückfluß erhitzt. Nach 12h wird nach dem Abkühlen ein gelbes Produkt abgesaugt und mit Methanol/Ether gewaschen.
1a) Auf diese Art wird beispielsweise ein Komplex des Typs (C^N)₂=Ir-µCl₂-Ir=(C^N)₂ gebildet mit (C^N)= 3- (4-Bromphenyl) - h-benzochinolin in einer Ausbeute von 65%.
   (Fp.:>300°C, λₘₐₓ =462nm THF, ESI-MS = 1783,7). 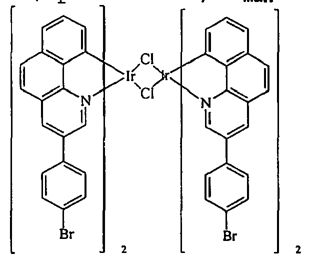
2) Allgemeine Vorschrift zur Synthese von (C^N)₂=Ir-(LX[**b-f**])-Komplexen:
   0,005 mol Ir-µ-chloro-komplex werden mit 2,1 Äquivalenten eines anionischen LX-Liganden **(b-f)** und 0,005 mol Natriumcarbonat in 30ml Ethoxyethanol refluxiert. Nach 12h rührt man das Produkt in die 5-fache Menge Methanol ein, saugt ab, wäscht mit Methanol/Ether und trocknet das Produkt.
2a) Auf diese Art wird beispielsweise ein Komplex des Typs (C^N)₂=Ir-(LX) gebildet mit (C^N)= 3-(4-Bromphenyl)-h-benzochinolin und LX = Acetylaceton in einer Ausbeute von 93%
   (Fp.:>300°C, λ_{max Emission}=587nm THF, ESI-MS = 956,1).

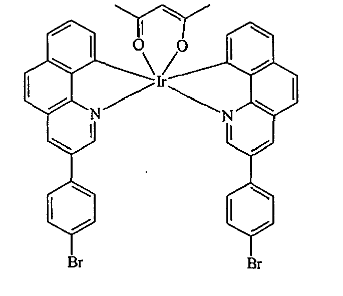

### 3) Allgemeine Vorschrift zur Synthese von (C^N)₂=Ir-(LX[a])-Komplexen:

0,005 mol (C^N)₂=Ir-(acac)-komplex werden mit 1,1 Äquivalenten eines LX-Liganden des Typs **(a)** in 30ml Glycerin refluxiert. Nach 12h rührt man das Produkt in die 5-fache Menge Methanol ein, saugt ab, wäscht mit Methanol/Ether und trocknet das Produkt.
3a) Auf diese Art wird beispielsweise ein Komplex des Typs (C^N)₂=Ir-(LX) gebildet mit (C^N)= 3-(4-Bromphenyl)-h-benzochinolin und LX = Phenylpyridin in einer Ausbeute von 74%
   (Fp.:>300°C, λ_{max Emission}=585nm THF, ESI-MS = 1011,2).

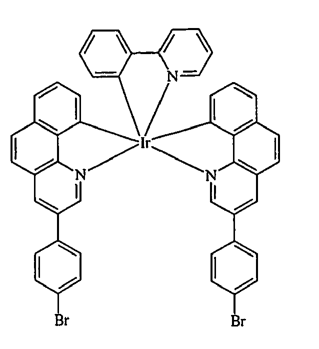

### Synthese der Grignardverbindungen D und F

0,25 mol frisch geätzte Magnesiumspäne werden unter Argonatmosphäre in trockenem Ether vorgelegt. Unter Rühren und Refluxieren werden 0,1 mol hochgereinigte und getrocknete Dibrom-arylenkomponente **M** (A) oder **TE** (C) gelöst in 300 ml THF so zugetropft, daß die Reaktionsmischung nach dem Reaktionsstart beim Sieden gehalten wird. Die Reaktion wird über Nacht fortgesetzt. Die Synthese der benötigten Grignardverbindungen sollte möglichst parallel durchgeführt werden, so daß sie am nächsten Tag zur Verfügung stehen. 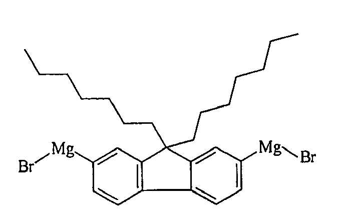
1a) Auf diese Art wird beispielsweise 9,9-Diheptyl-2,7-fluoren-ylen-magnesiumbromid aus 9,9-Diheptyl-2,7-dibromfluoren und Magnesium hergestellt. 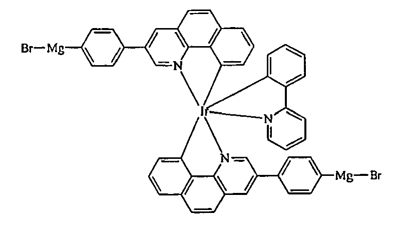
1b) Auf diese Art wird beispielsweise ein grignardierter Komplex des Typs (C^N)₂=Ir-(LX) gebildet mit (C^N)= 3-(Phenyl-4-yl-magnesiumbromid)-h-benzochinolin und LX = Phenylpyridin

### Alternative Synthese der lithiierten Verbindungen D,E und F

0,1 mol hochgereinigte und getrocknete Dibrom-arylenkomponente **M** (A) oder **TE** (C) bzw. die unbromierte Arylenkomponente **HT** (B) gelöst in 300 ml trockenem Ether/Toluol 1:1 werden unter Argonatmosphäre vorgelegt. Unter Rühren bei Raumtemperatur wird die jeweils äquivalente Menge Butyl-Lithium durch ein Septum eingespritzt. Die Synthesen der benötigten lithiierten Verbindungen sind nach 2h abgeschlossen und werden sofort den Folgereaktionen zugeführt. 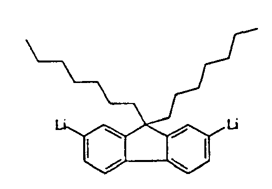
1a) Auf diese Art wird beispielsweise 9,9-Diheptyl-2,7-fluoren-ylen-lithium aus 9,9-Diheptyl-2,7-dibromfluoren und Butyllithium hergestellt. 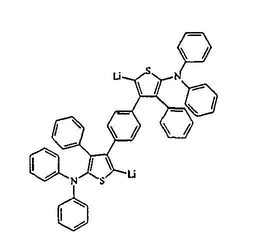
1b) Auf diese Art wird beispielsweise 2,2'-Diphenylamino-3,3'-diphenyl-5,5'-dilithio-4,4'-bisthienyl-p-phenylen aus 2,2'-Diphenylamino-3,3'-diphenyl-4,4'-bisthienyl-p-phenylen und Butyllithium hergestellt. 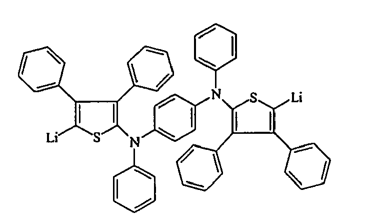
1c) Auf diese Art wird beispielsweise N,N'-Diphenyl-N,N'-di-[(3,4-diphenyl-5-yl-lithium)-thien-2yl]-phenylen-1,4-diamin aus N,N'-Diphenyl-N,N'-di-[(3,4-diphenyl)-thien-2yl]-phenylen-1,4-diamin und Butyllithium hergestellt. 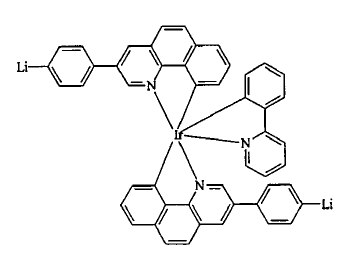
1d) Auf diese Art wird beispielsweise ein lithiierter Komplex des Typs (C^N)₂=Ir-(LX) gebildet mit (C^N)= 3-(Phenyl-4-yl-lithium)-h-benzochinolin und LX = Phenylpyridin.

### Synthese der linearen Co-polyfluorarylenborane H

Die gewünschten Anteile der vorbereiteten Grignardverbindungen bzw. alternativ lithiierten Verbindungen(D, E und F) gelöst in THF bzw. Ether/Toluol 1:1 werden unter Argon und Feuchtigkeitsausschluß in einen Kolben überführt, der mit Tropftrichter, Rückflußkühler, Rührer und Argonatmosphäre ausgestattet ist. Über ein Septum wird Bortrifuoridetherat entsprechend der Summe der molaren Anteile der metallorganischen Verbindungen in den Reaktionskolben über einen Zeitraum von 30 min eingespritzt und bei 60°C gerührt. Nach 2h Reaktionszeit steht das nun gebildete Co-polyfluorarylenboran **H** der nächsten Reaktion zur Verfügung. 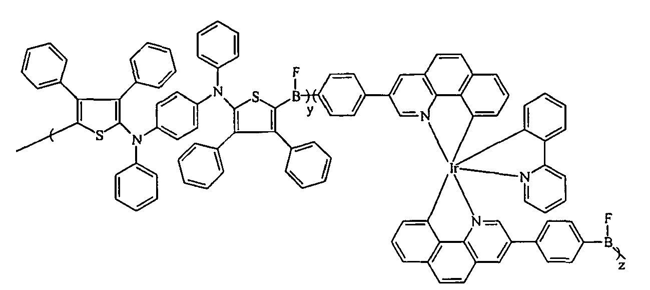
1a) Auf diese Art wird beispielsweise ein copolymeres Polyfluor-arylen-boran mit 98% HT- und 2% TE-Komponente aus den entsprechenden lithiierten HT- und TE-Komponenten (Beispiele s.o.) und Bortrifluoridetherat gebildet.

### Synthese der Grignardverbindungen I

0,15 mol frisch geätzte Magnesiumspäne werden unter Argonatmosphäre in trockenem Ether vorgelegt. Unter Rühren und Refluxieren werden 0,1 mol hochgereinigtes und getrocknetes Arylbromid gelöst in 150 ml THF so zugetropft, daß die Reaktionsmischung nach dem Reaktionsstart beim Sieden gehalten wird. Die Reaktion wird über Nacht fortgesetzt. Die auf diese Weise synthetisierte Grignardverbindung I sollte nach der Fertigstellung des Co-polyfluorarylenborans H zur Verfügung stehen. 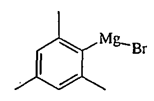
1a) Auf diese Art wird beispielsweise die Mesityl-grignardverbindung aus Mesitylbromid und Magnesium hergestellt.

### Alternative Synthese zu lithiierten Arylverbindungen I

0,01 mol hochgereinigte und getrocknete Arylkomponente I gelöst in 50 ml trockenem Ether/Toluol 1:1 werden unter Argonatmosphäre vorgelegt. Unter Rühren bei Raumtemperatur wird die äquivalente Menge Butyl-Lithium durch ein Septum eingespritzt. Die Synthese der benötigten lithiierten Verbindung ist nach 2h abgeschlossen und wird sofort der Folgereaktion zugeführt. 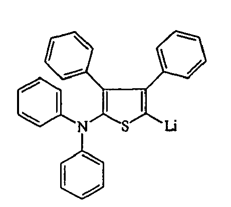
1a) Auf diese Art wird beispielsweise 2-Diphenylamino-3,4-diphenyl-thien-5-yl-lithium aus beispielsweise 2-Diphenylamino-3,4-diphenyl-thiophen und Butyllithium hergestellt.

### Synthese der phosphoreszierenden Co-Polyborane K

Voraussetzung ist die Apparatur mit dem bereitgestellten Co-polyfluorarylenboran **H** und eine metall-organische Verbindung **I.**
Zuerst wird der Rückflußkühler der Apparatur durch eine Destillationsbrücke ersetzt und das Lösungsmittel THF abdestilliert. Gleichzeitig wird der Tropftrichter etwa volumengleich der Reaktionsmischung mit trockenem Toluol befüllt und als Lösungsmittel anstelle des THF zugetropft. Nach Abschluß des Lösungsmittelaustausches wird die gewünschte gelöste Grignardverbindung **I** bzw. alternativ eine lithiierte Verbindung **I** unter Argonatmosphäre und Feuchtigkeitsausschluß in stöchiometrischem Verhältnis bezogen auf das Co-polyfluorarylenboran **H** in den Tropftrichter dosiert und bei leicht siedendem Toluol langsam zugetropft. Dabei destilliert man gleichzeitig das Lösungsmittel (THF oder Ether) der zutropfenden metallorganischen Verbindung **I** ab. Nach Abtrennung des THF bzw. Ether tauscht man die Destillationsbrücke wieder gegen den Rückflußkühler und erhitzt noch weitere 5h am Rückfluß. Die Reaktionsmischung wird nach Abkühlung auf Eis/HCl gegossen und die Toluolphase abgetrennt. Das Toluol wird am Rotationsverdampfer vollständig abdestilliert, danach der Rückstand in wenig THF gelöst und unter Rühren in Ethanol gefällt. Weitere Reinigung des Produktes erfolgt durch wiederholtes Lösen in THF und erneutes Ausfällen in Ethanol. Beispiel 30: 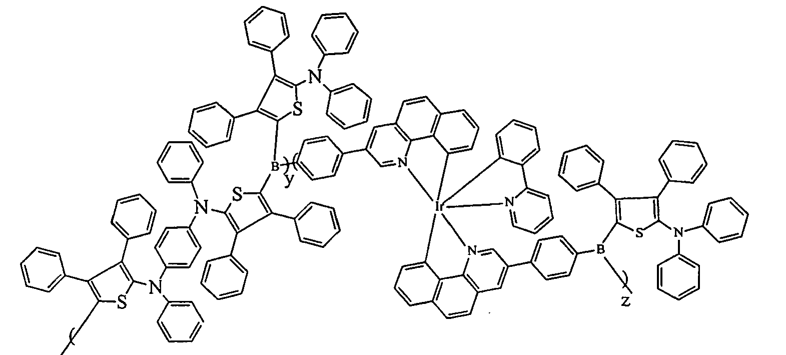
a) Auf diese Art wird beispielsweise ein Iridiumkomplexhaltiges, phosphoeszierendes Co-Polyboran **K** mit einem Komponentenverhältnis von M:HT:TE=0:49:1, Tg:85°C, λₘₐₓ =480nm, GPC: M_{w}=24500g/mol aus dem Co-polyfluorarylenboran **H** (1a) und 2-Diphenylamino-3,4-diphenyl-thien-5-yllithium **I** hergestellt.

### OLED Charakteristik

Eine OLED wurde durch folgende Schichtreihenfolge aufgebaut:
Anode: ITO (Indium-Zinnoxid)
120nm Pedot
80nm Emitter (nach Beispiel Copolyboran K a)
35nm Alq₃
Kathode 3nm LiF, 150nm Al

### a) Stromdichte

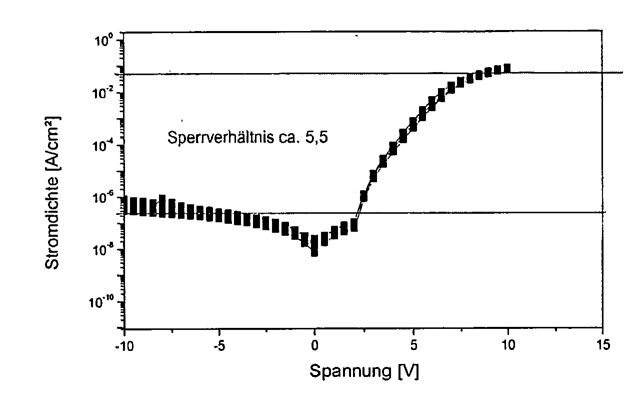

### b) Effizienz

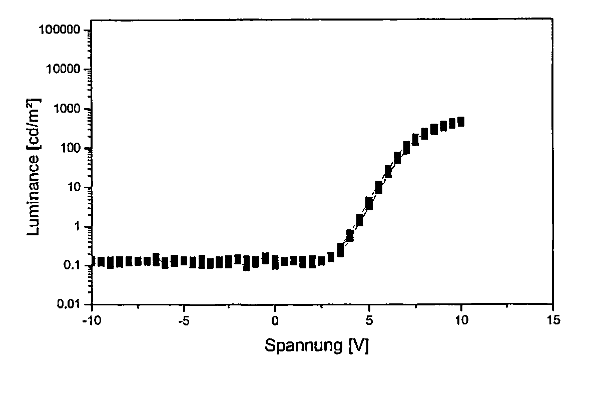

Die neuen Materialien eignen sich zur Erzeugung von elektrolumineszierenden Dioden in den verschiedenen Farben des sichtbaren Spektralbereiches (blau bis rot). Ebenso lassen sich diese Materialien durch Poly-co-reaktionen in entsprechenden Verhältnissen in Materialien umwandeln, die am bzw. in der Nähe des Weißpunktes elektrolumineszieren.

Diese polymeren Materialien lassen sich durch alle aus Lösung applizierbaren Verfahren verarbeiten (z. B. spin coating, Rakeln, Siebdrucken, Tintenstrahldrucken).

Die Materialien sind präperativ in hohen Ausbeuten zugänglich und leiten sich von triplett-emittierenden Emittern, die in arylierte Borane eingebunden sind ab, wobei durch die Wahl der Arylenfragmente (Donor/Akzeptor-Struktur) die elektronischen Eigenschaften und damit die Farbe der jeweiligen Verbindung beeinflußt wird.

Insbesondere ist hervorzuheben, dass zum Aufbau dieser polymeren Materialien keine wie sonst übliche metallkatalyse-basierende Kupplungsreaktionen benötigt werden, (damit entfällt auch die aufwendige Abtrennung des Katalysators sowie die Gefahr der Verunreinigung des Polymers durch Quencherpartikel), was die Kosten für die Synthese, infolge der nicht benötigten teuren Palladiumkatalysatoren und deren Abtrennung, stark reduziert.

Gerade weiß emittierende Materialien sind für die Herstellung von Leuchtquellen und vollfarbigen Displays, bei welchen die Vollfarbigkeit durch Filterung erreicht wird, von großem Interesse. Der Vorteil bei den Weißlicht getriebenen vollfarbigen Displays besteht in der farbunabhängigen Alterung des emittierenden Materials.

## Patentansprüche

1. Phosphoreszierende Copolyarylborane des Typs K, 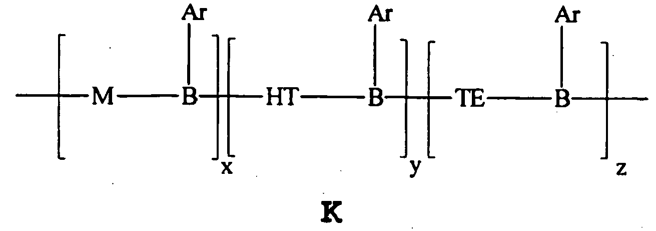 wobei Folgendes gilt:
**x,y** und **z** sind molare Teile von Komponenten und ergeben in Summe gleich 1,
an den Enden sind Wasserstoff-Atome gebunden,
**M, HT** und **TE** stehen für die Art der jeweiligen Arylenkomponente im Copolymer,
dabei dient **M** als Matrixstruktur und hat eine Arylenstruktur, wobei unter dem Begriff Arylenstruktur eine beliebige bivalent verbindende ein- oder mehrkernige aromatische und/oder heteroaromatische Struktur verstanden wird,
**HT** ist eine lochtransportfähige substituierte 2-Aminothiophen bzw. -thiazolstruktur,
**TE** ist ein bivalenter phosphoreszierender Organometallkomplex, folgender Struktur: 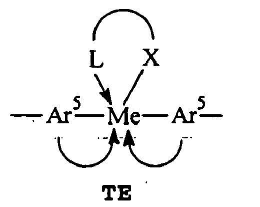
**Me** hat die Bedeutung eines Metalls der 8. Nebengruppe (Iridium, Ruthenium, Osmium oder Platin),
**Ar⁵** ist ein mit dem Metall komplexierbarer Arylenligand, der gleichzeitig auch eine Funktion zur polymeren Anbindung trägt,
der Ligand **(L-X)** gilt nicht für Platinkomplexe,
bei allen anderen Metallkomplexen hat **L-X** die Bedeutung eines komplexierbaren Arylenliganden
und
**Ar** ist ein carbocyclischer oder heterocyclischer Arylrest, dessen Wasserstoffatome auch beliebig durch einen oder mehrere verzweigte oder unverzweigte Alkylreste oder Alkoxyreste (C1 bis C10) sowie Phenylreste und/oder Diphenyl- bzw. Naphthylphenyl-amino-gruppierungen ersetzt sein können.

2. Phosphoreszierende Copolyarylborane nach Anspruch 1, wobei der Anteil **z** einen Wert von 0,01 bis 0,1 haben kann und die Verhältnisse der Teile **x** und **y** im Bereich der Differenz zu 1 frei wählbar sind.

3. Phosphoreszierende Copolyarylborane nach einem der Ansprüche 1 oder 2, wobei die Arylenstruktur **M** bevorzugt die 2,7-Fluorenylenstruktur, die in 9-Position durch unverzweigte und/oder verzweigte Alkylreste (C1 bis C10) substituiert sein kann, ist.

4. Phosphoreszierende Copolyarylborane nach einem der vorstehenden Ansprüche, wobei die Arylenstruktur **M** ausgewählt ist aus der Gruppe der folgenden Verbindungen **a** bis **x** 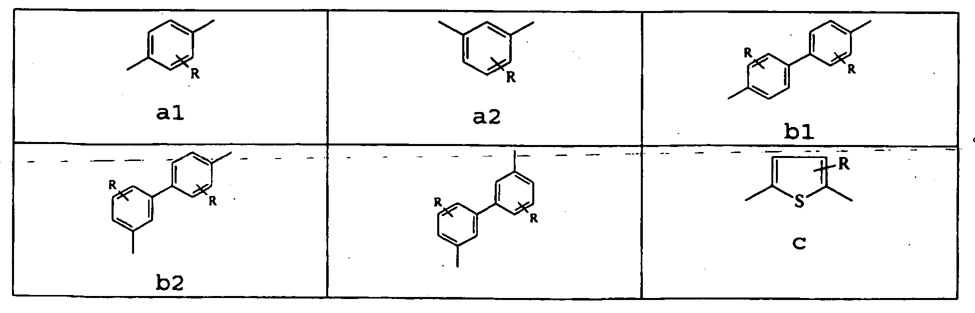 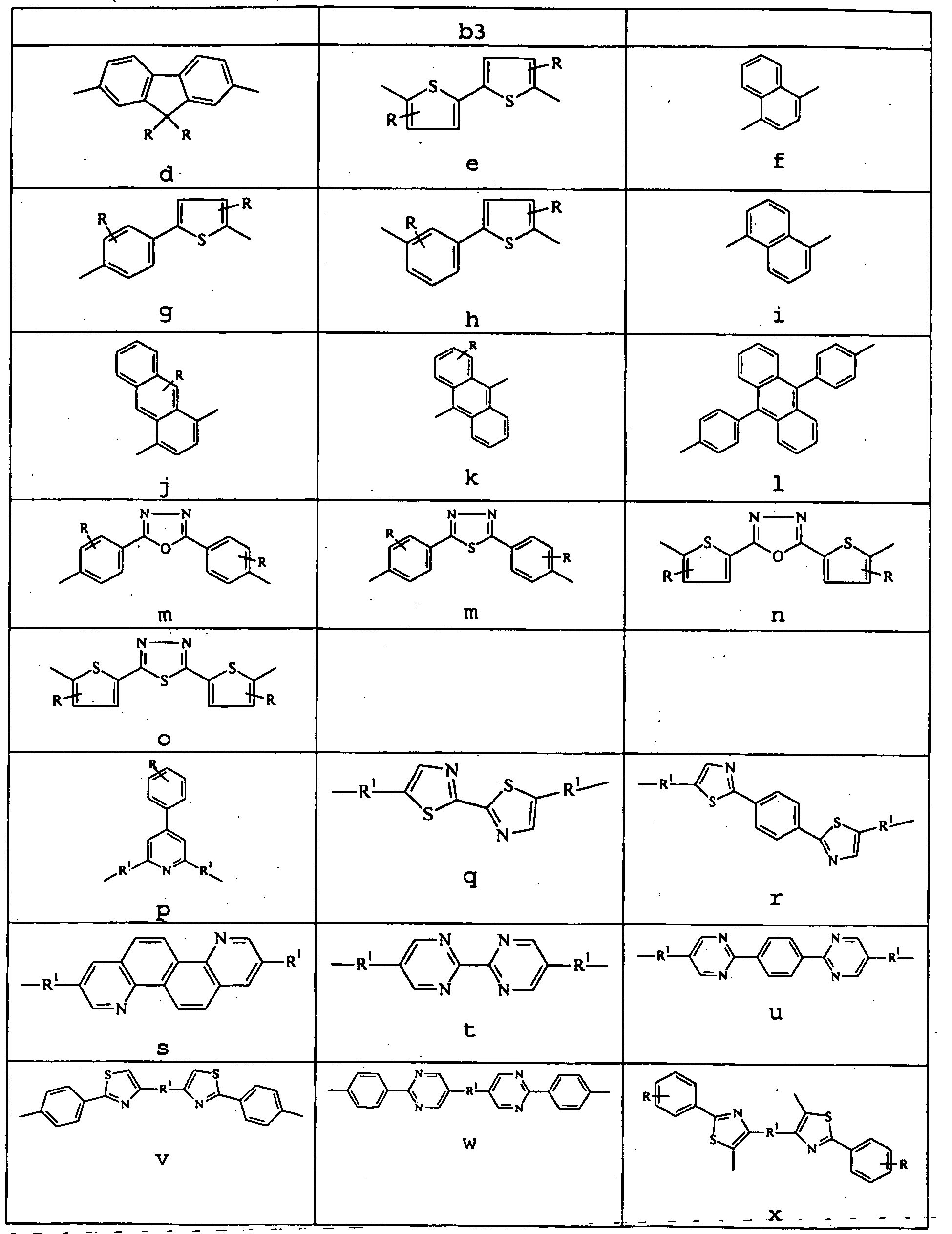 deren Löslichkeit in organischen Lösungsmitteln durch zusätzliche beliebige Anordnung von einem oder mehreren unverzweigten und/oder verzweigten Alkylsubstituenten und/oder Alkoxysubstituenten **R** und/oder aber auch durch alkylsubstituierte Arylen-Substituenten **R¹** modifizierbar ist, wobei bevorzugt einfach synthetisierbare mit verzweigten oder unverzweigten Alkylgruppierungen von C5 bis C10 ausgerüstete 2,7-disubstituierte 9,9-Dialkylflüorenylenstrukuren angewandt werden.

5. Phosphoreszierende Copolymere nach einem der vorstehenden Ansprüche, wobei die lochtransportfähige substituierte 2-Amino-thiophen oder -thiazolstruktur **HT** ausgewählt ist aus der Gruppe folgender Strukturen **HT(a)** bis **HT(c),** wobei
**HT(a)** eine substituierte (2,2'diamino-5,5'bisthienyl)-4,4'-ylen-Struktur,
**HT(b)** eine substituierte Bis-N,N'-(thien-2-yl)- bzw. Bis-N,N'-(1,3-thiazol-2-yl)-diaminoarylen-Struktur und
**HT(c)** eine substituierte (2,2'-Diamino)-bis-(4,4'thienyl)-arylen-5,5'-ylen-Struktur, jeweils gemäß den unten gezeigten Formeln, ist,
wobei die Substituenten **R²**, **R³** und **R⁴** Arylgruppierungen **Ar** darstellen, die wiederum durch zusätzliche beliebige Anordnung von einem oder mehreren unverzweigten und/oder verzweigten Alkylsubstituenten und/oder Alkoxysubstituenten **R** substituierbar sind, dabei sind die Bedeutungen der Substituenten **Rⁿ** mit gleichem Index **n** identisch und die der Substituenten **R¹** gleichbedeutend mit der Substituentenauswahl für die Arylenkomponente **Md;** und es gilt für **HT(b)** zusätzlich, dass **X** gleich **N** oder **C-R** ist

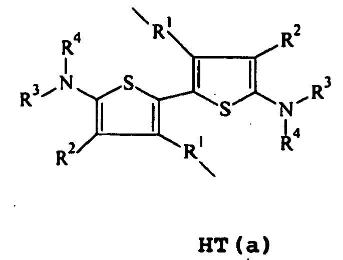

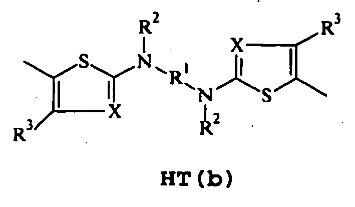

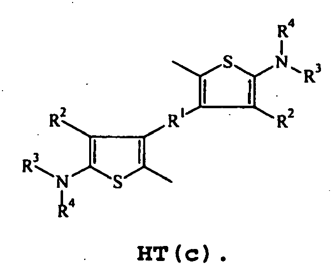

6. Phosphoreszierendes Copolymer nach einem der vorstehenden Ansprüche, wobei der carbocyclische oder heterocyclische Arylrest **Ar** ausgewählt ist aus der Gruppe folgender Verbindungen: Mesityl-, Phenyl-, Biphenylyl-, 1-Naphthyl, 2-Naphthyl-, 2-Diphenyl- bzw. 2-Naphthylphenylamino-3,4-diphenyl-thien-5-yl- und 2-Diphenyl- bzw. 2-Naphthylphenylamino-3,4-diphenyl-1,3-thiazol-5-yl.

7. Phosphoreszierendes Copolymer nach einem der vorstehenden Ansprüche, wobei der bivalente phosphoreszierende Organometallkomplex **TE** als Zentralatom **Me** Iridium hat.

8. Phosphoreszierendes Copolymer nach einem der vorstehenden Ansprüche, wobei der bivalente phosphoreszierende Organometallkomplex **TE** ausgewählt ist aus der Gruppe folgender Verbindungen **TE(a)** bis **TE(g)** und wobei der Ligand **L-X** ausgewählt ist aus der Gruppe der Verbindungen (a) bis (f), wobei **(a)** die Gruppe komplexierbarer Arylenliganden, **(b)** die der 1,3-Diketonatliganden, **(c)** die der Bis-thiazolylmethan- oder Bis-thiazolylamin-Liganden, **(d)** die der Picolinat-, **(e)** die der N-Alkylsalicylaldimino- und/oder **(f)** die der 8-Hyroxychinolat-Liganden umfasst:
a) Einkernkomplexe **TE(a)** bis **TE(g)**:
| | |
|---|---|
| 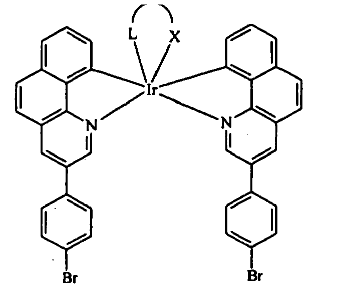 | 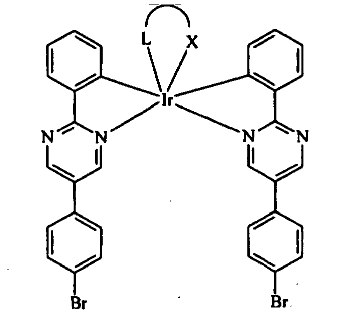 |
| **TE(a)** | **TE (b)** |
| 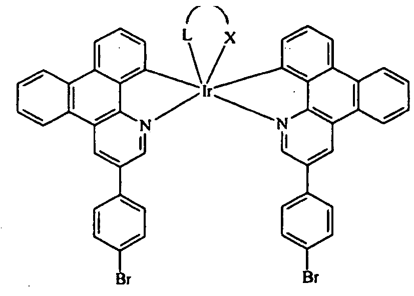 | |
| **TE(c)** | |
| 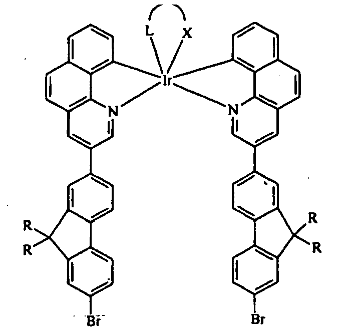 | 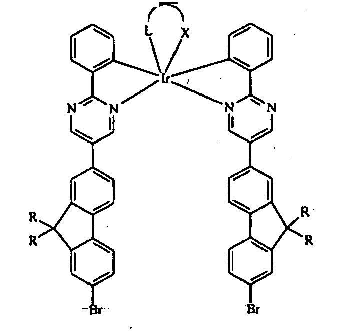 |
| **TE(d)** | **TE(e)** |
b) Zweikernkomplexe:
| |
|---|
| 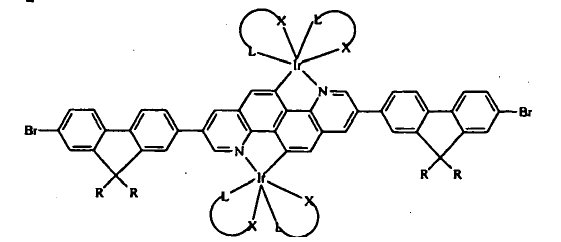 |
| **TE(f)** |
| 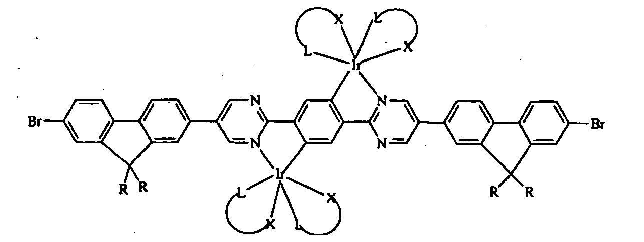 |
| **TE(g)** |
dazugehörige **L-X-Liganden:**
| | | | |
|---|---|---|---|
| 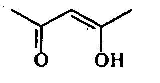 | | 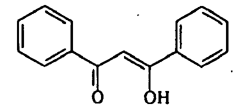 | 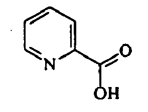 |
| **b1** | | **b2** | **d** |
| 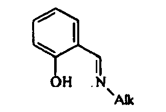 | | 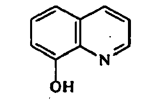 | 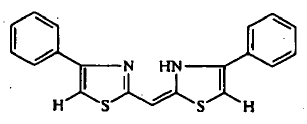 |
| **e** | | **f** | **c1** |
| 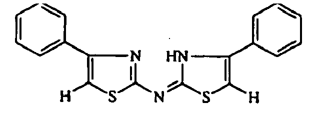 | | 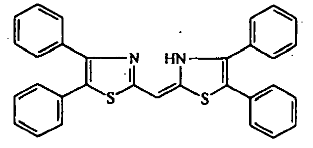 | 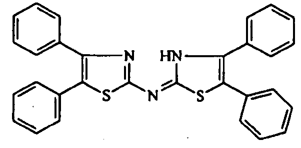 |
| **c2** | | **c3** | **c4** |
| 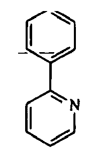 | | 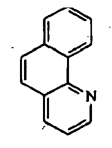 | 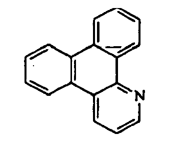 |
| **a1** | | **a2** | **a3** |
| 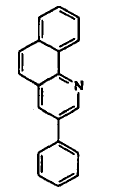 | 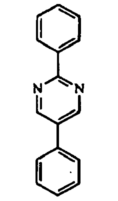 | 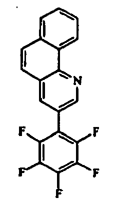 | 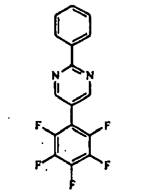 |
| **a4** | **a5** | **a6** | **a7** |

9. Verfahren zur Herstellung eines phosphoreszierenden Copolyarylborans vom Typ **K** nach dem allgemeinen Herstellungsschema 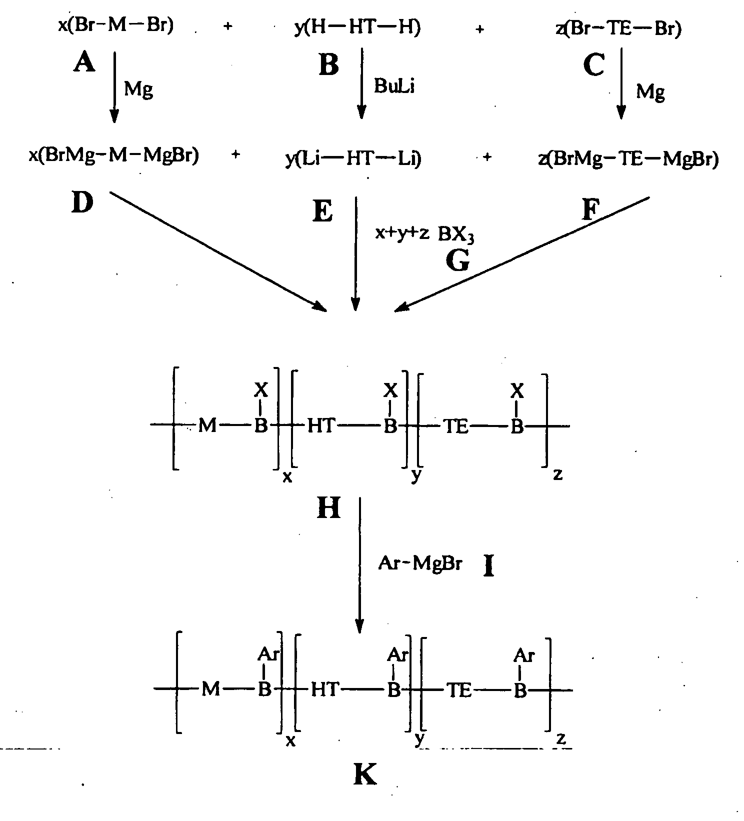 wobei von den bromsubstituierten Arylenkomponenten **M,** den Lochtransportkomponenten **HT** und den bromsubstituierten, phosphoreszierenden Organometallkomplexen **TE** ausgegangen wird, diese werden entweder in einer Grignardreaktion (siehe Schema) oder durch Lithiierung umgepolt und darauf folgend durch Bor substituiert, bei den Produkten **H** dieser Reaktion werden wiederum die Halogene am Bor mittels eines Grignard-Reagenzes (siehe Schema) oder eines entsprechenden lithiierten Reagenzes durch organische Reste **R** ersetzt.

10. Verwendung eines Copolyarylborans vom Typ **K** in organischen Leuchtdioden als triplett-emittierende und/oder Elektronen transportierende Schicht.

## Claims

1. Phosphorescent copolyarylboranes of the **K** type 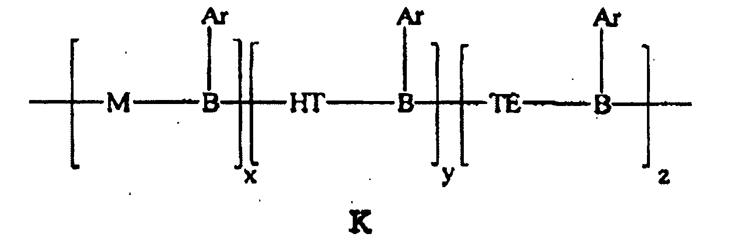 where:
**x, y** and **z** are molar portions of components and add up to 1,
hydrogen atoms are bonded at the ends,
**M, HT** and **TE** represent the type of the particular arylene component in the copolymer,
where **M** serves as the matrix structure and has an arylene structure, the term "arylene structure" being understood to mean any bivalently linking mono- or polycyclic aromatic and/or heteroaromatic structure,
**HT** is a substituted 2-aminothiophene or -thiazole structure capable of hole transport,
**TE** is a bivalent phosphorescent organometallic complex of the following structure: 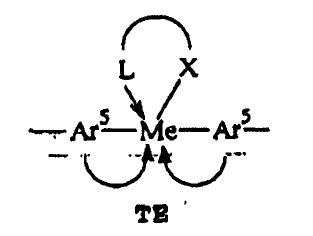
**Me** is defined as a metal of transition group 8 (iridium, ruthenium, osmium or platinum),
**Ar⁵** is an arylene ligand which is complexable to the metal and simultaneously also bears a function for polymeric attachment,
the ligand **(L-X)** does not apply to platinum complexes,
in all other metal complexes, **L-X** is defined as a complexable arylene ligand
and
**Ar** is a carbocyclic or heterocyclic aryl radical whose hydrogen atoms may also be replaced as desired by one or more branched or unbranched alkyl radicals or alkoxy radicals (C1 to C10) and phenyl radicals and/or diphenyl- or naphthylphenylamino moieties.

2. Phosphorescent copolyarylboranes according to Claim 1, wherein the proportion **z** may have a value of 0.01 to 0.1 and the ratios of the portions **x** and **y** are freely selectable within the range of the difference from 1.

3. Phosphorescent copolyarylboranes according to either of Claims 1 and 2, wherein the arylene structure **M** is preferably the 2,7-fluorenylene structure which may be substituted in the 9 position by unbranched and/or branched alkyl radicals (C1 to C10).

4. Phosphorescent copolyarylboranes according to any one of the preceding claims, wherein the arylene structure **M** is selected from the group of the following compounds **a** to **x** 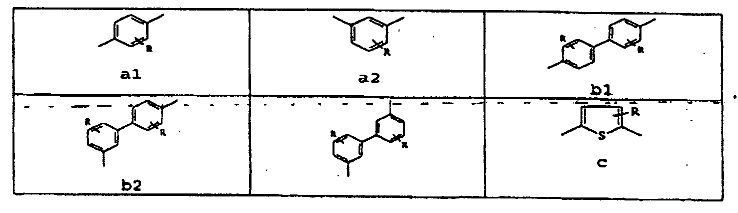 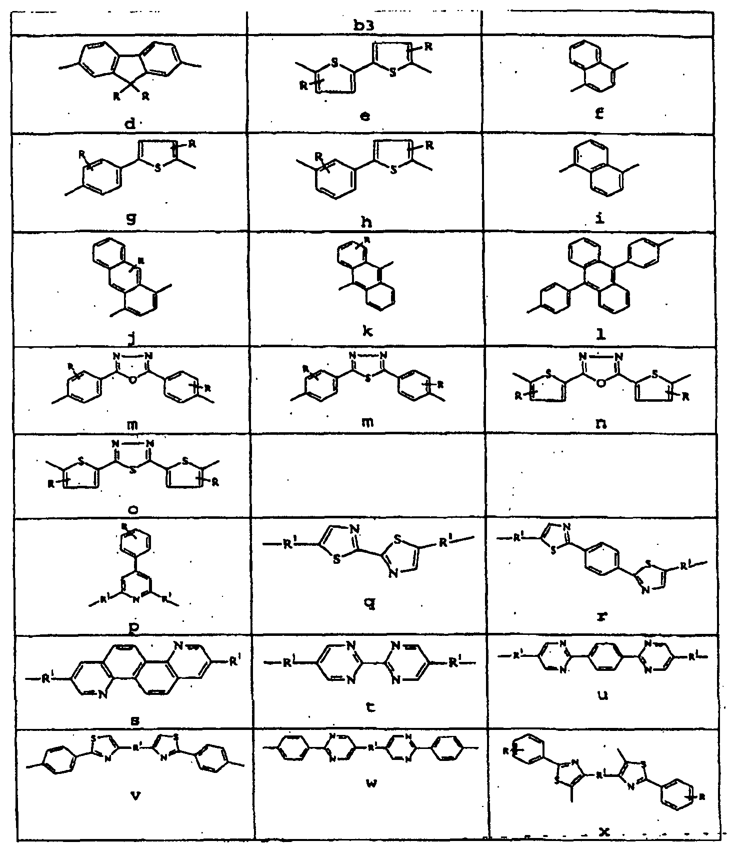 whose solubility in organic solvents can be modified by any additional arrangement of one or more unbranched and/or branched alkyl substituents and/or alkoxy substituents **R** and/or else by means of alkyl-substituted arylene substituents **R¹**, preference being given to employing easily synthesizable 2,7-disubstituted 9,9-dialkylfluorenyl structures modified with branched or unbranched alkyl moieties of C5- to C10.

5. Phosphorescent copolymers according to any one of the preceding claims, wherein the substituted 2-aminothiophene or -thiazole structure **HT** capable of hole transport is selected from the group of the following structures **HT(a)** to **HT(c),** where
**HT(a)** is a substituted (2,2'-diamino-5,5'bisthienyl)-4,4'-ylene structure,
**HT(b)** is a substituted bis-N,N'-(thien-2-yl)- or bis-N,N'-(1,3-thiazol-2-yl)diaminoarylene structure and
**HT(c)** is a substituted (2,2'-diamino)bis(4,4'-thienyl)arylen-5,5-ylene structure, in each case according to the formulae shown below,
where the substituents **R², R³** and **R⁴** are each aryl moieties **Ar** which can in turn be substituted by any additional arrangement of one or more unbranched and/or branched alkyl substituents and/or alkoxy substituents **R,** where the definitions of the substituents **Rⁿ** with the same index **n** are identical and those of the substituents **R¹** are the same as the selection of substituents for the arylene component **Md;** and, for **HT(b), x** is additionally **N** or **C-R**

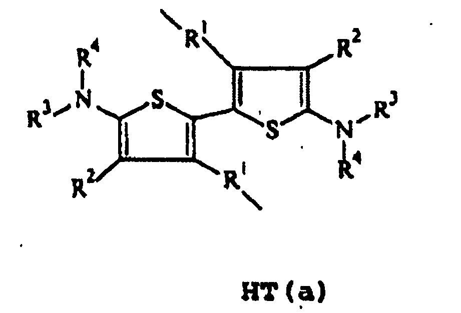

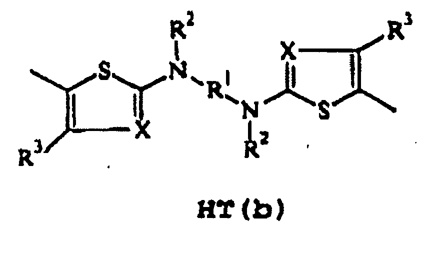

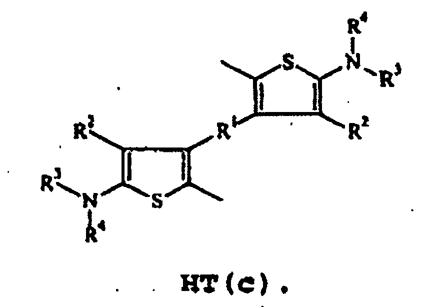

6. Phosphorescent copolymer according to any one of the preceding claims, wherein the carbocyclic or heterocyclic aryl radical **Ar** is selected from the group of the following compounds: mesityl, phenyl, biphenylyl, 1-naphthyl, 2-naphthyl, 2-diphenyl- or 2-naphthylphenylamino-3,4-diphenylthien-5-yl and 2-diphenyl- or 2-naphthylphenylamino-3,4-diphenyl-1,3-thiazol-5-yl.

7. Phosphorescent copolymer according to any one of the preceding claims, wherein the bivalent phosphorescent organometallic complex **TE** has iridium as the central atom **Me.**

8. Phosphorescent copolymer according to any one of the preceding claims, wherein the bivalent phosphorescent organometallic complex **TE** is selected from the group of the following compounds **TE(a)** to **TE(g)** and where the ligand **L-X** is selected from the group of the compounds (a) to (f), where (a) comprises the group of complexable arylene ligands, (b) that of the 1,3-diketonate ligands, (c) that of the bisthiazolylmethane or bisthiazolylamine ligands, (d) that of the picolinate ligands, (e) that of the N-alkylsalicylaldimino ligands and/or (f) that of the 8-hydroxyquinolate ligands:
a) Mononuclear complexes **TE(a)** to **TE(g):**
| | |
|---|---|
| 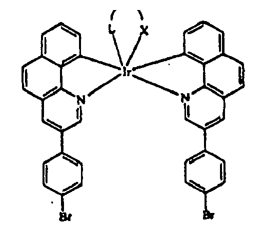 | 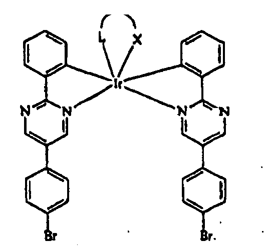 |
| **TE(a)** | **TE(b)** |
| 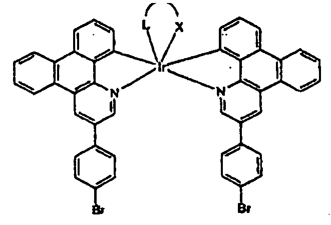 | |
| **TE(c)** | |
| 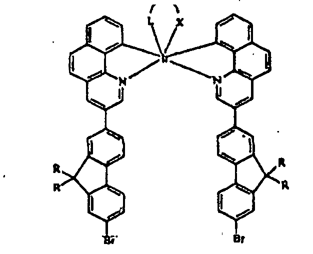 | 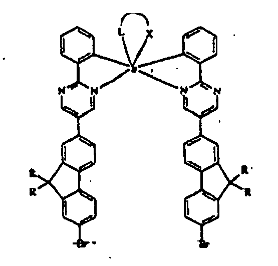 |
| **TE(d)** | **TE(e)** |
b) Binuclear complexes:
| |
|---|
| 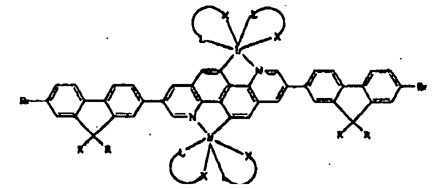 |
| **TE(f)** |
| 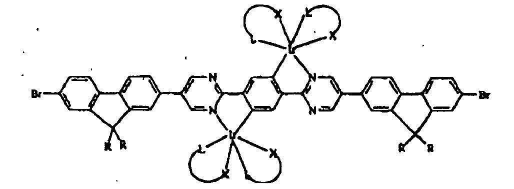 |
| **TE(g)** |
accompanying **L-X** ligands:
| | | | |
|---|---|---|---|
| 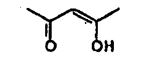 | | 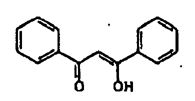 | 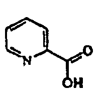 |
| **b1** | | **b2** | **d** |
| 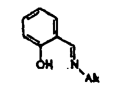 | | 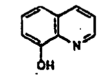 | 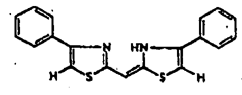 |
| **e** | | **f** | **c1** |
| 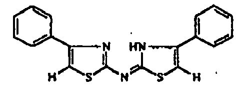 | | 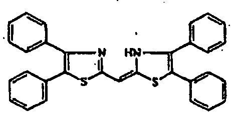 | 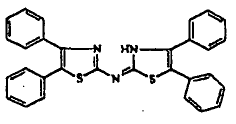 |
| **c2** | | **c3** | **c4** |
| 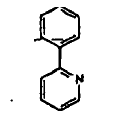 | | 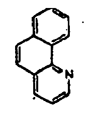 | 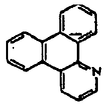 |
| **a1** | | **a2** | **a3** |
| 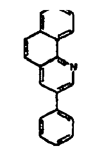 | 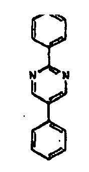 | 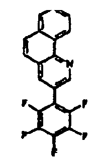 | 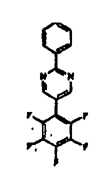 |
| **a4** | **a5** | **06** | **a7** |

9. Process for preparing a phosphorescent copolyarylborane of the **K** type according to the general preparation scheme 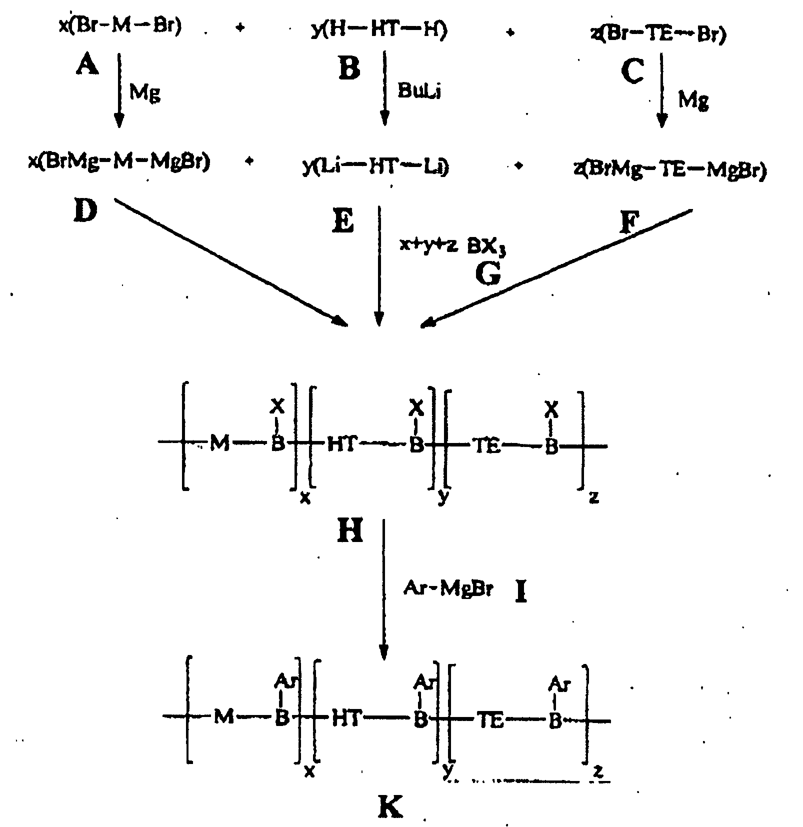 where the starting materials are the bromine-substituted arylene components **M,** the hole transport components **HT** and the bromine-substituted, phosphorescent organometallic complexes **TE,** and these are subjected to umpolung either in a Grignard reaction (see scheme) or by lithiation and then substituted by boron, and, in the products **H** of this reaction, the halogens on the boron are in turn replaced by organic **R** radicals by means of a Grignard reagent (see scheme) or of a corresponding lithiated reagent.

10. Use of a copolyarylborane of the **K** type in organic light-emitting diodes as a triplet-emitting layer and/or electron-transporting layer.

## Revendications

1. Copolyarylboranes phosphorescents du type K, 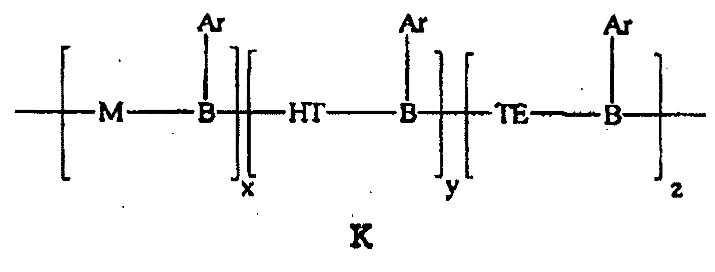 où :
**x, y** et **z** sont les parties molaires des composants et donnent un total égal à 1,
aux extrémités sont liés des atomes d'hydrogène,
**M, HT** et **TE** désignent la nature du composant arylène respectif dans le copolymère ;
ainsi **M** sert de structure matrice et a une structure arylène, en entendant par l'expression "structure arylène" une structure aromatique et/ou hétéroaromatique quelconque, mono- ou polynucléaire, à liaison bivalente,
**HT** est une structure 2-aminothiophène ou -thiazole substituée, apte au transport de trous,
**TE** est un complexe organométallique phosphorescent bivalent, de structure suivante : 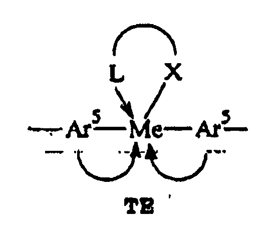
**Me** a la signification d'un métal du groupe 8B (iridium, ruthénium, osmium ou platine),
**Ar⁵** est un ligand arylène pouvant former un complexe avec le métal, qui porte en même temps également une fonction pour la liaison polymère,
le ligand **(L-X)** ne s'applique pas à des complexes de platine,
dans tous les autres complexes métalliques **L-X** a la signification d'un ligand arylène pouvant former un complexe
et
**Ar** est un radical aryle carbocyclique ou hétérocyclique, dont les atomes d'hydrogène peuvent également être remplacés de façon quelconque par un ou plusieurs radicaux alkyle ou radicaux alcoxy ramifiés ou non ramifiés (en C₁-C₁₀) ainsi que par un ou plusieurs radicaux phényle et/ou groupements diphényl- ou naphtylphénylamino.

2. Copolyarylboranes phosphorescents selon la revendication 1, dans lesquels la fraction **z** a une valeur de 0,01 à 0,1 et les rapports des parties **x** et **y** peuvent être librement choisis dans la plage de la différence par rapport à 1.

3. Copolyarylboranes phosphorescents selon la revendication 1 ou 2, dans lesquels la structure arylène **M** est de préférence la structure 2,7-fluorénylène, qui peut être substituée en position 9 par des radicaux alkyle (en C₁-C₁₀) ramifiés et/ou non ramifiés.

4. Copolyarylboranes phosphorescents selon l'une quelconque des revendications précédentes, dans lesquels la structure arylène **M** est choisie dans le groupe des composés **a** à **x** suivants 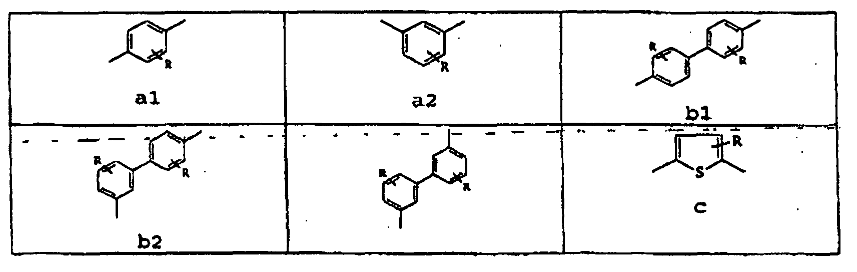 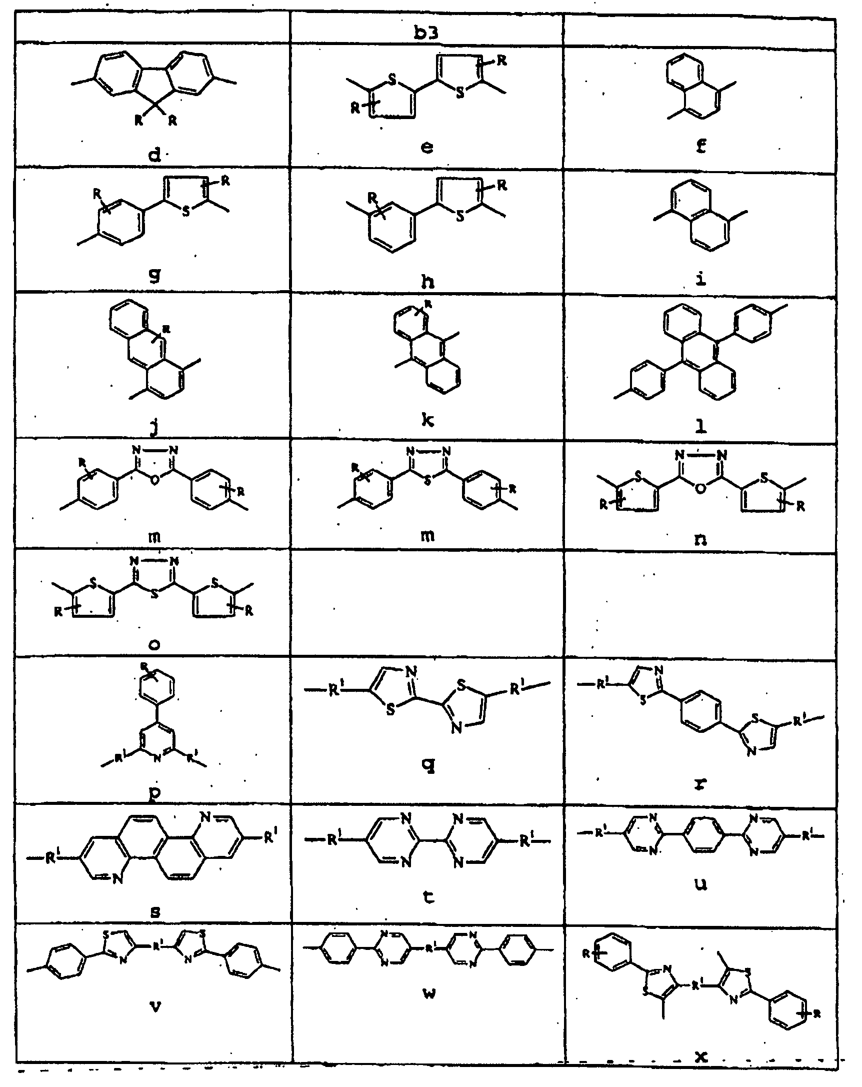 dont la solubilité dans des solvants organiques peut être modifiée par disposition supplémentaire quelconque d'un ou plusieurs substituants alkyle et/ou substituants alcoxy ramifiés et/ou non ramifiés **R** et/ou mais également par des substituants arylène **R¹** substitués par alkyle, en utilisant de préférence des structures 9,9-dialkylfluorénylène 2,7-disubstituées, munies de groupements alkyle en C₅-C₁₀ ramifiés ou non ramifiés, aisément synthétisables.

5. Copolymères phosphorescents selon l'une quelconque des revendications précédentes, dans lesquels la structure 2-aminothiophène ou -thiazole substituée **HT** apte au transport de trous est choisie dans le groupe des structures **HT(a)** à **HT(c)** suivantes,
**HT(a)** étant une structure (2,2'-diamino-5,5'-bisthiényl)-4,4'-ylène substituée,
**HT(b)** étant une structure bis-N,N'-(thién-2-yl)- ou bis-N,N'-(1,3-thiazol-2-yl)-diaminoarylène substituée et
**HT(c)** étant une structure (2,2'-diamino)-bis(4,4'-thiényl)-arylén-5,5'-ylène substituée, chaque fois selon les formules indiquées ci-dessous
les substituants **R², R³** et **R⁴** représentant des groupements aryle **Ar** qui peuvent à leur tour être substitués par une disposition supplémentaire quelconque d'un ou plusieurs substituants alkyle et/ou substituants alcoxy ramifiés et/ou non ramifiés **R,** les significations des substituants **Rⁿ** portant le même indice **n** étant en ce cas identiques et les significations des substituants **R¹** étant équivalentes au choix de substituants pour le composant arylène **Md ;** et il s'applique en outre pour **HT(b)** que **X** représente **N** ou **C-R**

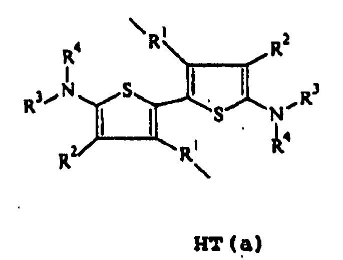

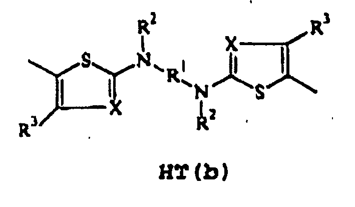

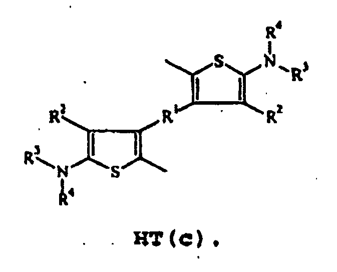

6. Copolymère phosphorescent selon l'une quelconque des revendications précédentes, dans lequel le radical aryle **Ar** carbocyclique ou hétérocyclique est choisi dans l'ensemble des groupes suivants : mésityl-, phényl-, biphénylyl-, 1-naphtyl-, 2-naphtyl-, 2-diphényl ou 2-naphtylphénylamino-3,4-diphényl-thién-5-yl- et 2-diphényl- ou 2-naphtylphénylamino-3,4-diphényl-1,3-thiazol-5-yle.

7. Copolymère phosphorescent selon l'une quelconque des revendications précédentes, dans lequel le complexe organométallique phosphorescent bivalent **TE** comporte comme atome central **Me** de l'iridium.

8. Copolymère phosphorescent selon l'une quelconque des revendications précédentes, dans lequel le complexe organométallique phosphorescent bivalent **TE** est choisi dans le groupe des composés **TE(a)** à **TE(g)** suivants, et dans lesquels le ligand L-X est choisi dans le groupe des composés **(a)** à **(f), (a)** comprenant le groupe des ligands arylène pouvant former des complexes, **(b)** comprenant celui des ligands 1,3-dicétonate, **(c)** comprenant celui des ligands bis-thiazolylméthane ou bisthiazolylamine, **(d)** comprenant celui des ligands picolinate, **(e)** comprenant celui des ligands N-alkylsalicylaldiimino et/ou **(f)** comprenant celui des ligands 8-hydroxyquinolate :
a) Complexes mononucléaires **TE(a)** à **TE(g) :**
| | |
|---|---|
| 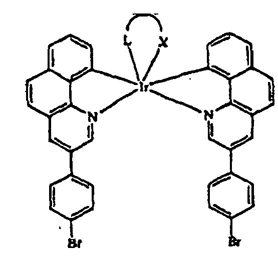 | 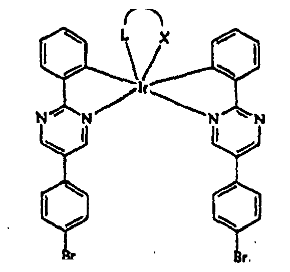 |
| **TE(a)** | **TE(b)** |
| 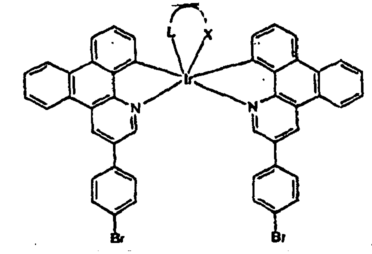 | |
| **TE(c)** | |
| 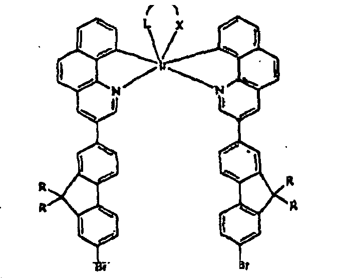 | 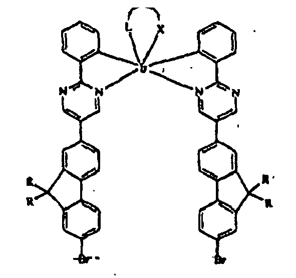 |
| **TE(d)** | **TE(e)** |
b) Complexes binucléaires :
| |
|---|
| 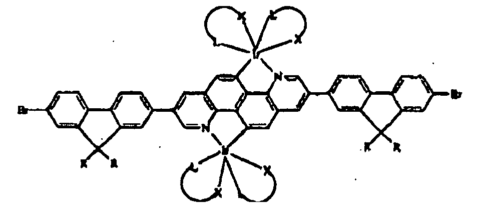 **TE(f)** |
| 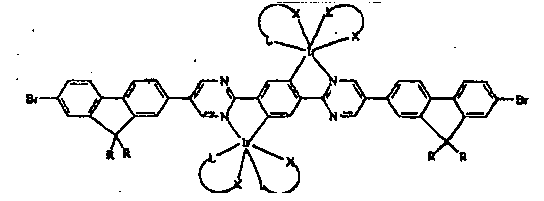 **TE(g)** |
Ligands **L-X** correspondants :
| | | | |
|---|---|---|---|
| 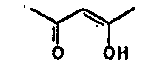 | | 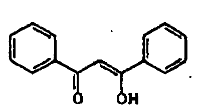 | 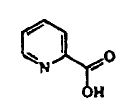 |
| **b1** | | **b2** | **d** |
| 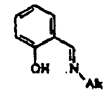 | | 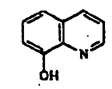 | 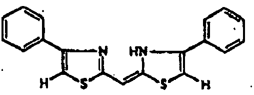 |
| **e** | | **f** | **c** |
| 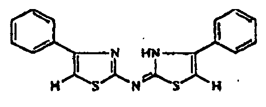 | | 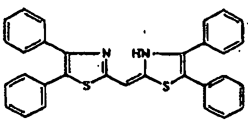 | 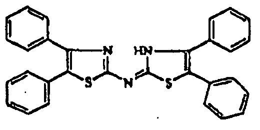 |
| **c2** | | **c3** | **c4** |
| 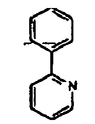 | | 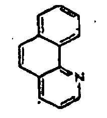 | 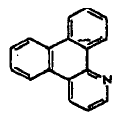 |
| **a1** | | **a2** | **a3** |
| 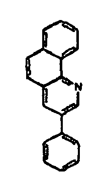 | 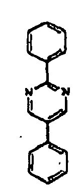 | 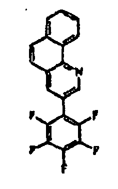 | 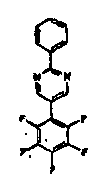 |
| **a4** | **a5** | **a6** | **a7** |

9. Procédé pour la préparation d'un copolyarylborane phosphorescent du type **K,** selon le schéma de préparation général 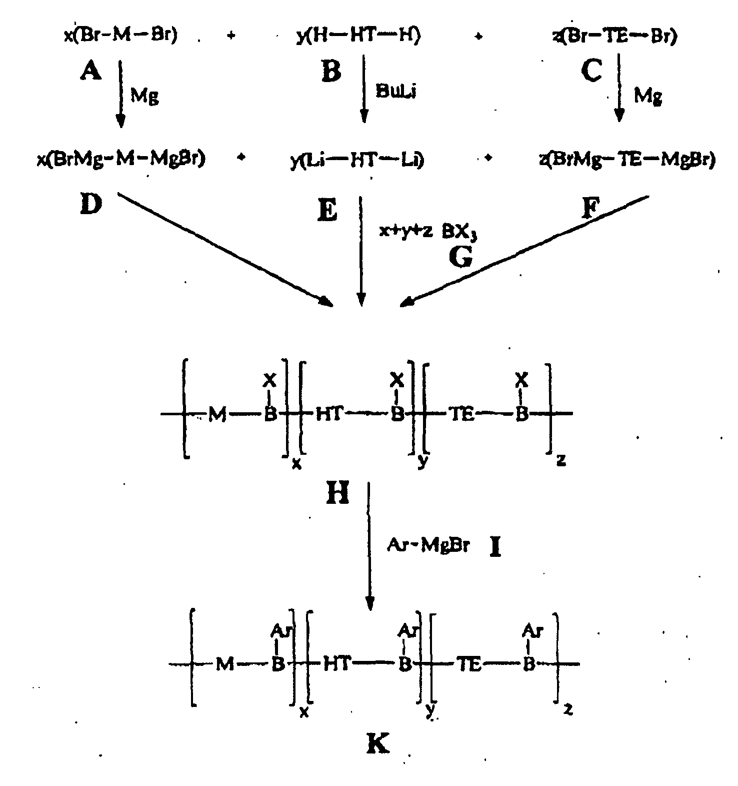 dans lequel on part des composants arylène bromo-substitués **M,** des composants transporteurs de trous **HT** et des complexes organométalliques phosphorescents bromo-substitués **TE,** on en inverse les pôles soit dans une réaction de Grignard (voir schéma), soit par lithiation, et on substitue ensuite par du bore, dans les produits **H** de cette réaction on remplace à nouveau les halogènes sur le bore par des radicaux organiques **R** au moyen d'un réactif de Grignard (voir schéma) ou d'un réactif lithié correspondant.

10. Utilisation d'un copolyarylborane du type **K** dans des diodes luminescentes organiques, en tant que couche émettrice de triplets et/ou transporteuse d'électrons.
